# EUROPEAN PATENT SPECIFICATION

(11) **EP 4 394 923 B1**
(45) Date of publication and mention of the grant of the patent: **11.11.2026**
(21) Application number: 22942952.7
(22) Date of filing: 02.11.2022
(51) Int. Cl.: C23C 16/02, C23C 16/04, C23C 16/24, C23C 16/44, C23C 16/46, H01M 4/36, H01M 4/38, H01M 4/62, H01M 4/13, H01M 4/139, H01M 4/587, H01M 10/0525

(54) **NEGATIVE ELECTRODE ACTIVE MATERIAL AND PREPARATION METHOD THEREFOR, SECONDARY BATTERY COMPRISING THE NEGATIVE ELECTRODE ACTIVE MATERIAL**
NEGATIVELEKTRODENAKTIVMATERIAL UND HERSTELLUNGSVERFAHREN DAFÜR, SEKUNDÄRBATTERIE MIT DEM NEGATIVELEKTRODENAKTIVMATERIAL
MATÉRIAU ACTIF D'ÉLECTRODE NÉGATIVE ET SON PROCÉDÉ DE PRÉPARATION, BATTERIE SECONDAIRE COMPRENANT LE MATÉRIAU ACTIF D'ÉLECTRODE NÉGATIVE

(43) Date of publication of application: 03.07.2024
(60) Divisional application: 26210216.3
(73) Proprietor: Contemporary Amperex Technology (Hong Kong) Limited, Central, Hong Kong (HK)
(72) Inventor: WU, Kai, Ningde, Fujian 352100 (CN); LV, Zijian, Ningde, Fujian 352100 (CN); WANG, Jiazheng, Ningde, Fujian 352100 (CN); LIU, Liangbin, Ningde, Fujian 352100 (CN); DENG, Jingxian, Ningde, Fujian 352100 (CN)
(74) Representative: Gong, Jinping
(86) International application number: PCT/CN2022/129318
(87) International publication number: WO 2024/092566

(56) References cited:
- EP-A2- 4 057 391
- WO-A1-2022/140978
- CN-A- 110 311 125
- CN-A- 110 380 029
- CN-A- 110 380 029
- CN-A- 114 695 865
- CN-A- 114 695 865
- KR-A- 20160 034 512
- KR-A- 20170 031 337
- US-A1- 2022 310 989
- US-A1- 2023 335 712

## Description

### TECHNICAL FIELD

The present application belongs to the field of battery technology, and in particular relates to a negative electrode active material and a method for preparation thereof, as well as a secondary battery comprising the same.

### BACKGROUND

In recent years, secondary batteries have been widely used in energy storage power systems such as hydraulic, thermal, wind and solar power plants, as well as in many fields such as electric tools, electric bicycles, electric motorcycles, electric vehicles, military equipment, and aerospace. In the rapid development of secondary batteries, higher requirements on energy density are put forward. Graphite is the most commonly used negative electrode active material for secondary batteries, but the capacity of graphite has been very close to its theoretical specific capacity of 372 mAh/g. In contrast, silicon has a theoretical specific capacity of up to 4200 mAh and is relatively low cost, thus has been attracting widespread attention. However, silicon has a huge volume effect in the process of charging and discharging, which may easily cause particle breakage and pulverization, thereby leading to relatively poor First Coulombic Cfficiency and relatively bad cycle performance and storage performance of secondary batteries. CN114695865A concerns a silicon negative electrode material and preparation method thereof, negative electrode plate and lithium ion battery. CN110380029A concerns a silicon-based negative electrode material for lithium batteries and preparation method thereof. WO 2022/140978 concerns a negative electrode plate, electrochemical device containing same, and electronic device.

### SUMMARY

An object of the present application is to provide a negative electrode active material and a method for preparation thereof, as well as a secondary battery as disclosed in the appended claims 1-19, wherein the negative electrode active material has high capacity, high First Coulombic Efficiency and low volume expansion, and can result in a secondary battery having high energy density, high First Coulombic Efficiency, long cycle life and long storage life at the same time.

The first aspect of the present application provides a negative electrode active material comprising a matrix material and a silicon-based material, the matrix material comprises a plurality of pore structures, at least a part of the silicon-based material is located in pore structures of the matrix material, at least a part of the silicon-based material has a crystalline structure, the silicon-based material comprises a first silicon-based material and a second silicon-based material with different grain sizes, and a ratio of grain size of the first silicon-based material to grain size of the second silicon-based material is (1.6-4): 1.

The negative electrode active material provided by the present application comprises a matrix material having a plurality of pore structures and a silicon-based material at least a part of which is located in the pore structures of the matrix material, and the silicon-based material comprises a first silicon-based material and a second silicon-based material with different grain sizes. The grain size of the first silicon-based material is relatively large, which helps to improve the First Coulombic Efficiency of the secondary battery. However, the first silicon-based material has large volume expansion and poor structural stability, which is not conducive to improving the cycle performance of the secondary battery and reducing the volume expansion of the secondary battery. The grain size of the second silicon-based material is relatively small, which is beneficial to improving the cycle performance of the secondary battery and reducing the volume expansion of the secondary battery, but the second silicon-based material may lead to low First Coulombic Efficiency, resulting in a large loss in actual capacity. The negative electrode active material provided by the present application comprises both the first silicon-based material with a relatively large grain size and the second silicon-based material with a relatively small grain size, thus the negative electrode active material provided by the application can have high capacity, high First Coulombic Efficiency and low volume expansion, and can further result in a secondary battery may having high energy density, high First Coulombic Efficiency, long cycle life and long storage life at the same time.

The ratio of grain size of the first silicon-based material to grain size of the second silicon-based material is (1.6-4): 1, and optionally (2-4): 1. As a result, the improvement effect of the first silicon-based material on the First Coulombic Efficiency and the improvement effect of the second silicon-based material on increasing the cycle performance and the reduction effect of the second silicon-based material on volume expansion can be better exerted.

The grain size of the first silicon-based material is greater than 0 nm and less than or equal to 20 nm, optionally from 2 nm to 20 nm. When the first silicon-based material has an appropriate grain size, the First Coulombic Efficiency of the secondary battery can be improved, and at the same time, a relatively large adverse effect on the cycle performance and storage performance of the secondary battery can be avoided.

The grain size of the second silicon-based material is greater than 0 nm and less than or equal to 12 nm, optionally from 1 nm to 12 nm. When the second silicon-based material has an appropriate grain size, it can not only improve the cycle performance and storage performance of the secondary battery, but also ensure that the secondary battery has a relatively high First Coulombic Efficiency.

A region formed by extending from outer surface of particle of the negative electrode active material to inside of the particle by a distance of 0.5 times a length between any point on the outer surface of the particle of the negative electrode active material and a core of the particle is recorded as an outer region, and a region inside the outer region is recorded as an inner region, and in cross-sectional image of the negative electrode active material, total cross-sectional area of the first silicon-based material in the outer region is smaller than total cross-sectional area of the first silicon-based material in the inner region; and total cross-sectional area of the second silicon-based material in the inner region is smaller than total cross-sectional area of the second silicon-based material in the outer region.

In any embodiment of the present application, a ratio α1 of the total cross-sectional area of the first silicon-based material in the outer region to the total cross-sectional area of the first silicon-based material in the inner region is (0-50): 100, optionally (0-10): 100.

In any embodiment of the present application, a ratio α2 of the total cross-sectional area of the second silicon-based material in the inner region to the total cross-sectional area of the second silicon-based material in the outer region is (0-30): 100, optionally (0-10): 100.

By using the first silicon-based material with a relatively large grain size mainly located in the inner region of the negative electrode active material, and using the second silicon-based material with a relatively small grain size mainly located in the outer region of the negative electrode active material, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted. As a result, the present application provides a negative electrode active material having high capacity, high First Coulombic Efficiency and low volume expansion, and can further result in a secondary battery better having high energy density, high First Coulombic Efficiency, long cycle life and long storage life at the same time.

In any embodiment of the present application, the cross-sectional image of the negative electrode active material comprises a cross-sectional image passing through the core of particle of the negative electrode active material.

In any embodiment of the present application, in the outer region of the cross-sectional image of the negative electrode active material, a ratio β1 of the total cross-sectional area of the first silicon-based material to the total cross-sectional area of the second silicon-based material is (0-25): 100, optionally (0-5): 100, and more optionally the total cross-sectional area of the first silicon-based material is 0. The outer region of the negative electrode active material mainly contains the second silicon-based material with a relatively small grain size and does not contain or contains a small amount of the first silicon-based material with a relatively large grain size. As a result, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted.

In any embodiment of the present application, in the inner region of the cross-sectional image of the negative electrode active material, a ratio β2 of the total cross-sectional area of the first silicon-based material to the total cross-sectional area of the second silicon-based material is 100:(0-250), optionally 100:(0-100). The inner region of the negative electrode active material may only contain the first silicon-based material with a relatively large grain size, or may simultaneously contain a mixture of the first silicon-based material with a relatively large grain size and the second silicon-based material with a relatively small grain size, and by further adjusting the total cross-sectional area of the first silicon-based material and the total cross-sectional area of the second silicon-based material within an appropriate range, the improvement effect of the first silicon-based material on the First Coulombic Efficiency can be better exerted.

In any embodiment of the present application, in the cross-sectional image of the negative electrode active material, the ratio γ1 of the total cross-sectional area of the first silicon-based material to the total cross-sectional area of the negative electrode active material is greater than 0 and less than or equal to 25%, and optionally from 5% to 20%. When the total cross-sectional area of the first silicon-based material is within the above ranges, not only the improvement effect of the first silicon-based material on the First Coulombic Efficiency can be fully exerted, and but also a relatively large adverse effect on the cycle performance and storage performance of the secondary battery can be avoided.

In any embodiment of the present application, in the cross-sectional image of the negative electrode active material, a ratio γ2 of the total cross-sectional area of the second silicon-based material to the total cross-sectional area of the negative electrode active material is greater than or equal to 35% and less than 100%, optionally from 40% to 60%. When the total cross-sectional area of the second silicon-based material is within the above-mentioned ranges, not only the improvement effect of the second silicon-based material on the cycle performance and reduction effect of the volume expansion can be fully exerted, and but also a relatively large adverse effect of the second silicon-based material on the First Coulombic Efficiency of the secondary battery can be avoided.

In any embodiment of the present application, mass percentage amount of the first silicon-based material in the silicon-based material is greater than 0 and less than or equal to 40 wt%, optionally from 10 wt% to 30 wt%. When the amount of the first silicon-based material is within the above ranges, not only the improvement effect of the first silicon-based material on the First Coulombic Efficiency can be fully exerted, and but also a relatively large adverse effect of the first silicon-based material on the cycle performance and storage performance of the secondary battery can be avoided.

In any embodiment of the present application, at least a part of the silicon-based material is located in the pore structures of the matrix material, and there is/are internal void(s) between the silicon-based material and the matrix material. When there is/are internal void(s) between the silicon-based material and the matrix material, this part of the internal void(s) can serve as a space for accommodating the volume expansion of the silicon-based material, and buffer the stress generated during the expansion process of the silicon-based material.

In any embodiment of the present application, the first silicon-based material comprises one or more of elemental silicon, silicon oxide, silicon-carbon material, silicon-nitrogen composite, and silicon alloy, optionally comprises elemental silicon.

In any embodiment of the present application, the second silicon-based material comprises one or more of elemental silicon, silicon oxide, silicon-carbon material, silicon-nitrogen composite, and silicon alloy, optionally comprises elemental silicon.

In any embodiment of the present application, the materials of the first silicon-based material and the second silicon-based material are the same, and optionally, both the first silicon-based material and the second silicon-based material are elemental silicon.

In any embodiment of the present application, the first silicon-based material comprises vapor deposited silicon-based materials, and optionally vapor deposited elemental silicon.

In any embodiment of the present application, the first silicon-based material comprises elemental silicon, and the grain size of the first silicon-based material is greater than 0 nm and less than or equal to 8 nm, optionally from 2 nm to 8 nm. As a result, the First Coulombic Efficiency of the secondary battery can be improved, and at the same time, a relatively large adverse effect on the cycle performance and storage performance of the secondary battery can be avoided; in addition, it also helps to improve the specific capacity of the negative electrode active material.

In any embodiment of the present application, the first silicon-based material comprises elemental silicon, and the grain size of the first silicon-based material is greater than 0 nm and less than or equal to 5 nm, optionally from 1 nm to 5 nm. As a result, it can not only improve the cycle performance and storage performance of the secondary battery, but also ensure that the secondary battery has a relatively high First Coulombic Efficiency; in addition, it also helps to improve the specific capacity of the negative electrode active material.

In any embodiment of the present application, the matrix material has a porosity of from 30% to 60%, optionally from 40% to 50%. When the porosity of the matrix material is within the above ranges, it is beneficial to accommodating sufficient silicon-based materials, which in turn is beneficial to increasing the energy density of the secondary battery.

In any embodiment of the present application, the matrix material comprises one or more of carbon material, graphite material and transition metal oxide material.

In any embodiment of the present application, the matrix material comprises a carbon material, and the carbon material comprises one or more of activated carbon, biomass carbon, pyrolytic carbon and resin carbon. As a result, in addition to alleviating the volume expansion of the silicon-based material and improving the conductivity of the silicon-based material, it can also promote the transmission of active ions and increase the specific capacity of the negative electrode active material. Furthermore, it also helps the dispersion of the silicon-based material.

In any embodiment of the present application, the negative electrode active material further comprises a coating layer which is located on at least part of surface of the matrix material. By using the coating layer located on the outside of the negative electrode active material, it can further prevent a direct contact between the silicon-based material and an electrolyte, and reduce the reactivity of the silicon-based material after contact with air, thereby reducing side reaction of the electrolyte and reducing the consumption of active ions and improving the cycle performance of the secondary battery.

In any embodiment of the present application, the coating layer comprises one or more of carbon materials, conductive polymers, metal oxides and metal sulfides.

In any embodiment of the present application, the coating layer comprises carbon material, and optionally, the carbon material comprises one or more of hard carbon, soft carbon, graphene, carbon fiber, and carbon nanotube. When the coating layer comprises carbon material, it further helps to improve the conductivity of the silicon-based material.

In any embodiment of the present application, the coating layer has a thickness of from 0 nm to 200 nm, optionally from 10 nm to 150 nm. When the thickness of the coating layer is within the above ranges, it is beneficial for the negative electrode active material to having high specific capacity and low volume expansion.

In any embodiment of the present application, the negative electrode active material comprises carbon element and silicon element.

In any embodiment of the present application, mass percentage amount of carbon element in the negative electrode active material is from 40 wt% to 60 wt%, optionally from 45 wt% to 50 wt%.

In any embodiment of the present application, mass percentage amount of silicon in the negative electrode active material is from 38 wt% to 58 wt%, optionally from 40 wt% 55 wt%.

When the amount of carbon element and/or the amount of silicon element in the negative electrode active material is within the above range, it is beneficial for the negative electrode active material to having both high specific capacity and high conductivity.

In any embodiment of the present application, the negative electrode active material further comprises other element(s) including one or more of oxygen element, metal element and nitrogen element.

In any embodiment of the present application, a sum of mass percentage amount(s) of other element(s) in the negative electrode active material is from 0 wt% to 20 wt%, optionally from 0 wt% 10 wt%.

In any embodiments as described above, the negative electrode active material has a pore volume of from 0.001 cm³/g to 0.02 cm³/g, optionally from 0.01 cm³/g to 0.02 cm³/g. When the pore volume of the negative electrode active material is within the above ranges, the internal void(s) of the negative electrode active material is/are in an appropriate range, which on the one hand can improve the specific capacity and the First Coulombic Efficiency of the negative electrode active material, and on the other hand can buffer the stress generated during the expansion process of the silicon-based material.

In any embodiment of the present application, the negative electrode active material has an average particle size Dv50 of from 4 µm to 12 µm. When the average particle size Dv50 of the negative electrode active material is within the above range, it helps to reduce surface activity, reduce interfacial side reactions, reduce the consumption for SEI film formation, and also helps to improve active ion and electron transmission performance, thereby further improving the cycle performance of the secondary battery.

In any embodiment of the present application, the negative electrode active material has a BET specific surface area of from 1 m²/g to 15 m²/g. When the BET specific surface area of the negative electrode active material is within the above range, it helps to reduce surface activity, reduce interfacial side reactions, reduce the consumption for SEI film formation, and improve the First Coulombic Efficiency and cycle performance of the secondary battery.

The second aspect of the present application provides a method for preparing a negative electrode active material, comprising the steps of: providing a matrix material comprising a plurality of pore structures; dispersing a silicon-based material into the pore structures of the matrix material to obtain a negative electrode active material, wherein the negative electrode active material comprises a matrix material and a silicon-based material, the matrix material comprises a plurality of pore structures, and at least a part of the silicon-based material is located in pore structures of the matrix material, at least a part of the silicon-based material has a crystalline structure, the silicon-based material comprises a first silicon-based material and a second silicon-based material with different grain sizes, and a ratio of grain size of the first silicon-based material to grain size of the second silicon-based material is 1.6-4:1.

In any embodiment of the present application, the matrix material has a porosity of from 30% to 60%, optionally from 40% to 50%. When the porosity of the matrix material is within the above ranges, it is beneficial to proceeding smoothly the deposition process, and it is also beneficial for the negative electrode active material to having a suitable content of silicon element, a suitable specific surface area and/or a suitable pore volume.

In any embodiment of the present application, the matrix material comprises one or more of carbon material, graphite material and transition metal oxide material.

In any embodiment of the present application, the matrix material comprises a carbon material, and the carbon material comprises one or more of activated carbon, biomass carbon, pyrolytic carbon and resin carbon.

In any embodiment of the present application, the matrix material has an average particle size Dv50 of from 4 µm to 12 µm. When the average particle size Dv50 of the matrix material is within the above range, it is beneficial to proceeding smoothly the deposition process, and it is also beneficial for the negative electrode active material to having a suitable content of silicon element, a suitable specific surface area and/or a suitable pore volume.

The step of dispersing the silicon-based material into the pore structures of the matrix material comprises the following steps of: placing the matrix material comprising a plurality of pore structures as a substrate in a reaction furnace, and feeding a first mixture gas comprising silicon source gas and depositing at a first temperature T₁ for a first time t₁, stopping feeding of the first mixture gas at the end of depositing; when the temperature in the furnace drops to the second temperature T₂, feeding a second mixture gas comprising silicon source gas, and depositing at a second temperature T₂ for a second time t₂, and after the end of depositing, a negative electrode active material is obtained, wherein a region formed by extending from outer surface of particle of the negative electrode active material to inside of the particle by a distance of 0.5 times a length between any point on the outer surface of the particle of the negative electrode active material and a core of the particle is recorded as an outer region, and a region inside the outer region is recorded as an inner region, and in cross-sectional image of the negative electrode active material, total cross-sectional area of the first silicon-based material in the outer region is smaller than total cross-sectional area of the first silicon-based material in the inner region; and total cross-sectional area of the second silicon-based material in the inner region is smaller than total cross-sectional area of the second silicon-based material in the outer region.

In any embodiment of the present application, the method further comprises the steps of: before feeding the first mixture gas comprising silicon source gas, placing the matrix material comprising a plurality of pore structures as a substrate in the reaction furnace, and purging with a protective gas for purge treatment and pre-heating treatment, optionally, the temperature for pre-heating is from 200°C to 300°C. This facilitates the removal of residual moisture in the matrix material, and further facilitates subsequent deposition to form the first silicon-based material with a relatively large grain size.

In any embodiment of the present application, a volume percentage V₁ of the silicon source gas in the first mixture gas is greater than a volume percentage V₂ of the silicon source gas in the second mixture gas. This helps to adjust the distribution area of the first silicon-based material and the second silicon-based material so that the first silicon-based material is mainly located in the inner region of the negative electrode active material and the second silicon-based is mainly located in the outer region of the negative electrode active material. As a result, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted.

In any embodiment of the present application, T₁>T₂. By adjusting the first temperature during deposition to be greater than the second temperature, it is beneficial to adjusting the distribution area of the first silicon-based material and the second silicon-based material so that the first silicon-based material is mainly located in the inner region of the negative electrode active material and the second silicon-based is mainly located in the outer region of the negative electrode active material. As a result, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted.

In any embodiment of the present application, t₁<t₂. By adjusting the first time during deposition to be shorter than the second time, it is beneficial to adjusting the amount and distribution area of the first silicon-based material.

In any embodiment of the present application, the first mixture gas comprises a silicon source gas and a protective gas, and optionally, the volume percentage V₁ of the silicon source gas in the first mixture gas is from 10% to 50%.

In any embodiment of the present application, the first mixture gas has a total gas flow rate of from 0.5 L/min to 20 L/min.

In any embodiment of the present application, the first temperature T₁ is from 500°C to 700°C.

In any embodiment of the present application, the first time t₁ is from 0.5 h to 8 h, optionally from 0.5 h to 4 h.

By adjusting at least one of the composition of the first mixture gas, the total gas flow rate of the first mixture gas, the first temperature, and the first time within the above ranges, it is beneficial to forming the first silicon-based material with a relatively large grain size, and it is also beneficial to adjusting parameters such as distribution area and deposition amount of the first silicon-based material.

In any embodiment of the present application, the second mixture gas comprises a silicon source gas and a protective gas, and optionally, the volume percentage V₂ of the silicon source gas in the second mixture gas is from 10% to 25%.

In any embodiment of the present application, the second mixture gas has a total gas flow rate of from 0.5 L/min to 20 L/min.

In any embodiment of the present application, the second temperature T₂ is from 500°C to 600°C.

In any embodiment of the present application, the second time t₂ is from 4 h to 20 h, optionally from 4 h to 16 h.

By adjusting at least one of the composition of the second mixture gas, the total gas flow rate of the second mixture gas, the second temperature, and the second time within the above ranges, it is beneficial to forming the second silicon-based material with a relatively small grain size, and it is also beneficial to adjusting parameters such as distribution area and deposition amount of the second silicon-based material.

In any embodiment of the present application, the total gas flow rate of the second mixture gas is the same as that of the first mixture gas.

In any embodiment of the present application, the method also comprises the following step of: forming a coating layer on at least part of surface of the obtained negative electrode active material, and the coating layer comprises one or more of carbon materials, conductive polymers, metal oxides and metal sulfides.

In any embodiment of the present application, the step of forming a coating layer comprising the following steps of: placing the obtained negative electrode active material in a reaction furnace, feeding the third mixture gas containing carbon source gas, and depositing at a third temperature T₃ for a third time t₃, to obtain a carbon-coated negative electrode active material. This facilitates the formation of a uniform carbon layer.

In any embodiment of the present application, the third mixture gas comprises a carbon source gas and a protective gas, and optionally, the volume percentage V₃ of the carbon source gas in the third mixture gas is from 10% to 50%.

In any embodiment of the present application, the third mixture gas has a total gas flow rate of from 0.5 L/min to 20 L/min.

In any embodiment of the present application, the third temperature T₃ is from 600°C to 800°C.

In any embodiment of the present application, the third time t is from 0.5 h to 4 h.

By adjusting at least one of the composition of the third mixture gas, the total gas flow rate of the third mixture gas, the third temperature, and the third time within the above ranges, it is beneficial to forming a coating layer having a suitable thickness and avoiding a coating layer having an excessive thickness which may reduce the First Coulombic Efficiency and/or specific capacity of the negative electrode active material.

A third aspect of the present application provides a secondary battery, comprising a negative electrode plate, said negative electrode plate comprises the negative electrode active material of the first aspect of this application or the negative electrode active material prepared by the method of the second aspect of this application.

The negative electrode active material provided by the present application has high capacity, high First Coulombic Efficiency and low volume expansion, and can further result in a secondary battery better having high energy density, high First Coulombic Efficiency, long cycle life and long storage life at the same time. The electrical device of the present application comprises the secondary battery provided by the present application, and thus has at least the same advantages as the secondary battery.

### DESCRIPTION OF THE DRAWINGS

In order to explain the technical solutions of the embodiments of the present application more clearly, the following will briefly introduce the drawings that need to be used in the embodiments of the present application.
Fig. 1 is a schematic diagram of a cross-sectional image of an embodiment of a negative electrode active material of the present application.
Fig. 2 is a schematic diagram of a battery cell according to an embodiment of the present application.
Fig. 3 is a schematic exploded diagram of a battery cell according to an embodiment of the present application.
Fig. 4 is a schematic diagram of a battery module according to an embodiment of the present application.
Fig. 5 is a schematic diagram of a battery pack according to an embodiment of the present application.
Fig. 6 is a schematic exploded diagram of the embodiment of the battery pack as shown in Fig. 5.
Fig. 7 is a schematic diagram of an embodiment of an electrical device of the present application as a powder supply.

In the drawings, the drawings are not necessarily drawn to scale. The reference numerals are defined as follows: 1- battery pack; 2- upper case body; 3-lower case body; 4-battery module; 5- battery cell; 51- housing; 52-electrode assembly; 53- cover; 100-negative electrode active material; 101-outer region; 102-inner region; O-core of particle.

### DETAILED DESCRIPTION

Hereafter, embodiments of the negative electrode active material and method for preparation thereof, secondary battery comprising same of the present application will be specifically described in detail with appropriate references to the accompanying drawings. However, unnecessary detailed description may be omitted. For example, detailed descriptions of well-known items and repeated descriptions of substantially the same configurations may be omitted. This is to avoid the following description from becoming unnecessarily lengthy and to facilitate the understanding of those skilled in the art. In addition, the drawings and the following description are provided for those skilled in the art to fully understand the present application.

A "range" disclosed herein is defined in terms of lower and upper limits, and a given range is defined by selecting a lower limit and an upper limit that define the boundaries of the particular range. Ranges defined in this manner may be inclusive or exclusive of end values and may be combined arbitrarily, that is, any lower limit may be combined with any upper limit to form a range. For example, if ranges of 60-120 and 80-110 are listed for a particular parameter, it is to be understood that ranges of 60-110 and 80-120 are also contemplated. Additionally, if the minimum range values 1 and 2 are listed, and the maximum range values 3, 4, and 5 are listed, the following ranges are all expected: 1-3, 1-4, 1-5, 2-3, 2-4 and 2-5. In the present application, unless stated otherwise, the numerical range "a-b" represents an abbreviated representation of any combination of real numbers between a and b, where both a and b are real numbers. For example, the numerical range "0-5" means that all real numbers between "0-5" have been listed herein, and the range "0-5" is just an abbreviated representation of the combination of these numerical values. In addition, when a parameter is expressed as an integer greater than or equal to 2, it is equivalent to disclose that the parameter is, for example, an integer of 2, 3, 4, 5, 6, 7, 8, 9, 10, 11, 12, and the like.

Unless stated otherwise, all the embodiments and the optional embodiments of the present application can be combined with each other to form a new technical solution, and such a technical solution should be considered to be included in the disclosure of the present application.

Unless stated otherwise, all technical features and optional technical features of the present application can be combined with each other to form a new technical solution, and such a technical solutions should be considered to be included in the disclosure of the present application.

Unless stated otherwise, all steps of the present application can be carried out sequentially, and also can be carried out randomly, preferably they are carried out sequentially. For example, the method includes steps (a) and (b), indicating that the method may include steps (a) and (b) performed in sequence, or that the method may include steps (b) and (a) performed in sequence. For example, reference to the method further comprising step (c) indicates that step (c) may be added to the method in any order. As an example, the method may comprises steps (a), (b) and (c), steps (a), (c) and (b), or steps (c), (a) and (b), and the like.

Unless stated otherwise, the transition phases "comprising" and "including" mentioned in the present application means that it is drafted in an open mode or in a close mode. For example, the transition phases "comprising" and "including" may mean that other components not listed may also be included or contained, or only the listed components may be included or contained.

In the present application herein, unless otherwise stated, the term "or" is inclusive. For example, the phrase "A or B" means "A, B, or both A and B." More specifically, any of the following conditions satisfy the condition "A or B": A is true (or exists) and B is false (or does not exist); A is false (or does not exist) and B is true (or exists); or both A and B are true (or exist).

The terms "first", "second" and the like in the present application are used to distinguish different objects, rather than to describe a specific sequence or primary-subordinate relationship, unless otherwise clearly specified.

In this application, the terms "plurality", "a plurality of" and "multiple" and "several" refer to two or more.

In this application, "mainly located" in a specific region (such as an inner region or an outer region) means that at least half of the corresponding material (for example, the first silicon-based material or the second silicon-based material) is located in the specific region, and also includes the situation that the corresponding material (for example, the first silicon-based material or the second silicon-based material) are all located in the specific region (for example, the inner region or the outer region).

Unless otherwise specified, the terms used in this application have the well-known meanings generally understood by those skilled in the art.

Unless otherwise specified, a numerical value for each parameter mentioned in the present application can be determined by various test methods commonly used in the art, for example, can be determined according to the test methods given in the Examples of the present application.

Silicon has a theoretical specific capacity of up to 4200 mAh/g, which can significantly increase the energy density of secondary batteries; silicon further has a voltage platform slightly higher than graphite, so the negative electrode is not easy to form dendrites, which can improve the safety performance of secondary batteries; silicon is widely distributed in the earth's crust, rich in resources, and low in price, which can reduce the production cost of secondary batteries. Therefore, materials containing silicon (hereinafter referred to as silicon-based materials) have become extremely potential negative electrode active materials.

However, silicon-based materials still have some disadvantages. In contrast to carbon-based materials such as graphite, silicon-based materials react with metals (such as lithium, sodium, etc.) through an alloying reaction during charging and discharging, so there is a huge volume effect, which may easily cause particle breakage and pulverization, in turn lead to the problem of pulverization in the negative electrode film layer, and easily cause a loss of electrical contact with the current collector. In addition, due to the volume effect of silicon-based materials, the solid electrolyte interface (SEI) film on the particle surface will be repeatedly destroyed and rebuilt, further increasing the irreversible consumption of active ions and ultimately affecting the capacity of the secondary battery. Therefore, when silicon-based materials are used as negative electrode active materials, they usually have the defects of high irreversible capacity, low First Coulombic Efficiency and large volume expansion, thereby leading to large loss of actual capacity and poor cycle life of secondary batteries.

In addition, silicon is a semiconductor material with low intrinsic conductivity. When used as a negative electrode active material, it will affect the capacity exertion of the secondary battery, or it requires an additionally increased amount of conductive agent, which will reduce actual coating weight of the negative electrode active material and affect the energy density of secondary batteries.

To date, the main modification methods for the purpose of solving the above problems include the following aspects.

(1) Reducing the size of silicon-based materials to the nanometer level to alleviate their volume effect. However, the inventors of the present application have found that the high specific surface area of nano-silicon-based materials will further intensify interfacial side reactions, increase the irreversible consumption of active ions, and reduce the first Coulombic Efficiency.

(2) Preparing a porous silicon-based material, and utilizing its own deformation to alleviate the volume effect. However, the inventors of the present application have found that the volume effect cannot be effectively alleviated when a porous silicon-based material is used, meanwhile the improvement of the first Coulombic Efficiency is very limited.

(3) Coating the surface of the silicon-based material with a conductive carbon layer to increase the conductivity of the silicon-based material and alleviate the volume effect. However, the inventors of the present application have found that when the conductive carbon layer is too thin, the coating is incomplete, which leads to rapid capacity decay and short cycle life of the secondary battery; when the conductive carbon layer is too thick, its rigidity is stronger, and the secondary battery is more prone to breakage and pulverization during charging and discharging, and the improvement of the First Coulombic Efficiency is also very limited.

Therefore, none of the above modification methods can make the secondary battery having high energy density, high First Coulombic Efficiency, low volume expansion and long cycle life at the same time.

In view of this, through extensive research, the inventors of the present application propose a new type of negative electrode active material which has high capacity, high First Coulombic Efficiency and low volume expansion, and can result in a secondary battery better having high energy density, high First Coulombic Efficiency, long cycle life and long storage life at the same time.

### Negative electrode active material

The first aspect of embodiments of the present application provides a negative electrode active material. The negative electrode active material comprises a matrix material and a silicon-based material, the matrix material comprises a plurality of pore structures, at least a part of the silicon-based material is located in pore structures of the matrix material, at least a part of the silicon-based material has a crystalline structure, the silicon-based material comprises a first silicon-based material and a second silicon-based material with different grain sizes, and a ratio of grain size of the first silicon-based material to grain size of the second silicon-based material is (1.6-4):1.

The negative electrode active material provided by the present application comprises a matrix material having a plurality of pore structures and a silicon-based material at least a part of which is located in the pore structures of the matrix material, and the silicon-based material comprises a first silicon-based material and a second silicon-based material with different grain sizes. The grain size of the first silicon-based material is relatively large, which helps to improve the First Coulombic Efficiency of the secondary battery. However, the first silicon-based material has large volume expansion and poor structural stability, which is not conducive to improving the cycle performance of the secondary battery and reducing the volume expansion of the secondary battery. The grain size of the second silicon-based material is relatively small, which is beneficial to improving the cycle performance of the secondary battery and reducing the volume expansion of the secondary battery, but the second silicon-based material may lead to low First Coulombic Efficiency, resulting in a large loss in actual capacity. The negative electrode active material provided by the present application comprises both the first silicon-based material with a relatively large grain size and the second silicon-based material with a relatively small grain size, thus the negative electrode active material provided by the application can have high capacity, high First Coulombic Efficiency and low volume expansion, and can further result in a secondary battery may having high energy density, high First Coulombic Efficiency, long cycle life and long storage life at the same time.

The ratio of the grain size of the first silicon-based material to the grain size of the second silicon-based material is (1.6-4):1, and optionally (2-4):1. As a result, the improvement effect of the first silicon-based material on the First Coulombic Efficiency and the improvement effect of the second silicon-based material on increasing the cycle performance and the reduction effect of the second silicon-based material on volume expansion can be better exerted.

The grain size of the first silicon-based material is greater than 0 and less than or equal to 20 nm, and for example, it may be 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm or in the ranges formed from any of the above values. Optionally, the grain size of the first silicon-based material is from 2 nm to 20 nm. When the grain size of the first silicon-based material is relatively large, it is beneficial to improving the First Coulombic Efficiency of the secondary battery, but is unfavorable to cycle performance and storage performance of the secondary battery. Therefore, when the first silicon-based material has an appropriate grain size, the First Coulombic Efficiency of the secondary battery can be improved, and at the same time, a relatively large adverse effect on the cycle performance and storage performance of the secondary battery can be avoided.

The grain size of the second silicon-based material is greater than 0 and less than or equal to 12 nm, and for example, it may be 1 nm, 2 nm, 2.5 nm, 3 nm, 3.5 nm, 4 nm, 4.5 nm, 5 nm, 6 nm, 7 nm, 8 nm, 9 nm, 10 nm, 11 nm, 12 nm, or in the ranges formed from any of the above values. Optionally, the grain size of the second silicon-based material is from 1 nm to 12 nm. When the grain size of the second silicon-based material is relatively small, it is beneficial to improving the cycle performance and storage performance of the secondary battery, but is unfavorable to First Coulombic Efficiency of the secondary battery. Therefore, when the second silicon-based material has an appropriate grain size, it can not only improve the cycle performance and storage performance of the secondary battery, but also ensure that the secondary battery has a relatively high First Coulombic Efficiency.

The grain sizes of the first silicon-based material and the second silicon-based material have meanings well-known in the art, and can be measured with instruments and methods well-known in the art. For example, a High Resolution Transmission Electron Microscope (HRTEM) test may be used.

A region formed by extending from outer surface of particle of the negative electrode active material to inside of the particle by a distance of 0.5 times a length between any point on the outer surface of the particle of the negative electrode active material and a core of the particle is recorded as an outer region, and a region inside the outer region is recorded as an inner region. In cross-sectional image of the negative electrode active material, total cross-sectional area of the first silicon-based material in the outer region is smaller than total cross-sectional area of the first silicon-based material in the inner region; and total cross-sectional area of the second silicon-based material in the inner region is smaller than total cross-sectional area of the second silicon-based material in the outer region.

By using the first silicon-based material with a relatively large grain size mainly located in the inner region of the negative electrode active material, and using the second silicon-based material with a relatively small grain size mainly located in the outer region of the negative electrode active material, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted. As a result, the present application provides a negative electrode active material having high capacity, high First Coulombic Efficiency and low volume expansion, and can further result in a secondary battery better having high energy density, high First Coulombic Efficiency, long cycle life and long storage life at the same time.

In this application, the following description "total cross-sectional area of the first silicon-based material in the outer region is smaller than total cross-sectional area of the first silicon-based material in the inner region" is not limited to the case that the outer region must contain the first silicon-based material; when the outer region does not contain the first silicon-based material, i.e. the corresponding total cross-sectional area of the first silicon-based material in the outer region is 0, it is also considered that the requirement "total cross-sectional area of the first silicon-based material in the outer region is smaller than total cross-sectional area of the first silicon-based material in the inner region" is met.

In this application, the following description "total cross-sectional area of the second silicon-based material in the inner region is smaller than total cross-sectional area of the second silicon-based material in the outer region" is not limited to the case that the inner region must contain the second silicon-based material; when the inner region does not contain the second silicon-based material, i.e. the corresponding total cross-sectional area of the second silicon-based material in the inner region is 0, it is also considered that the requirement "total cross-sectional area of the second silicon-based material in the inner region is smaller than total cross-sectional area of the second silicon-based material in the outer region" is met.

In this application, dual beam focused ion beam microscope (Dual Beam FIB-SEM) may be used to prepare a cross-section of the negative electrode active material particle, which cross section passes through the central region of the negative electrode active material, optionally through the particle core of the negative electrode active material, and then the cross-sectional image characteristics of the negative electrode active material can be observed by using a Transmission Electron Microscope (TEM for short) or a High Resolution Transmission Electron Microscope (HRTEM for short). When the cross-sectional image of the negative electrode active material is observed, the areas of the lattice fringe regions formed by the first silicon-based material and the second silicon-based material are different, which makes it easy to distinguish the first silicon-based material and the second silicon-based material.

In the present application, the cross-sectional image of the negative electrode active material comprises a cross-sectional image passing through the core of particle of the negative electrode active material.

In the present application, "particle core" or "core of particle" refers to the intersection point of the longest diameter (or longest diagonal) and shortest diameter (or shortest diagonal) of particle of the negative electrode active material.

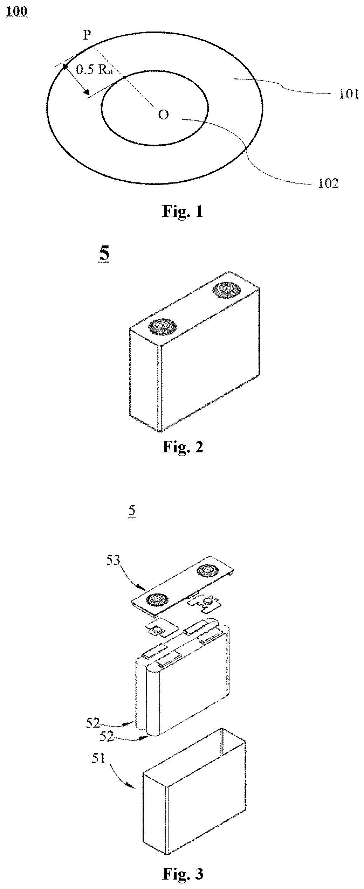

Fig. 1 is a schematic diagram of a cross-sectional image of an embodiment of a negative electrode active material 100 of the present application and the cross-sectional image passes through the core of particle of the negative electrode active material. As shown in Fig. 1, the negative electrode active material 100 comprises an outer region 101 and an inner region 102 located inside the outer region 101, the intersection point of the longest diameter (or longest diagonal) and the shortest diameter (or shortest diagonal) of the negative electrode active material particle is the particle core O, and the length between any point P on the outer surface of the particle and the particle core O is recorded as Rₙ, and the region formed by extending from the outer surface of the particle of the negative electrode active material to inside of the particle by the distance of 0.5 times the length Rₙ between any point P on the outer surface of the particle and the core O of the particle is recorded as the outer region 101.

It should be noted that the "length Rₙ" refers to the length from any point on the outer surface of the particle to the core of particle. When the negative electrode active material has a regular or irregular shape other than a non-ideal spherical shape, the length Rₙ is expressed as a variable value, that is, the distance from different positions on the outer surface of the particle to the core of particle is a constantly changing value, so the distance extending from different positions on the outer surface of the particle to the inside of the particle is also a constantly changing value. Therefore, after all points on the outer surface of the negative electrode active material particle extend a corresponding distance to the inside of the particle (that is, 0.5 Rₙ), the region enclosed by all the points and the outer surface of the particle is the outer region.

In some embodiments, in the cross-sectional image of the negative electrode active material, a ratio α1 of the total cross-sectional area of the first silicon-based material in the outer region to the total cross-sectional area of the first silicon-based material in the inner region is (0-50):100, optionally (0-40):100, (0-30):100, (0-20):100, (0-15):100, (0-10):100, and (0-5):100. In some embodiments, in cross-sectional image of the negative electrode active material, the ratio α1 of the total cross-sectional area of the first silicon-based material in the outer region to the total cross-sectional area of the first silicon-based material in the inner region is 0, that is, the above-mentioned outer region of the negative electrode active material does not contain the first silicon-based material with a relatively large grain size.

By making the first silicon-based material mainly located in the inner region of the negative electrode active material, not only the improvement effect of the first silicon-based material on the First Coulombic Efficiency can be fully exerted, and but also a relatively large adverse effect of the first silicon-based material on the cycle performance and storage performance of the secondary battery can be avoided.

In some embodiments, in the cross-sectional image of the negative electrode active material, a ratio α2 of the total cross-sectional area of the second silicon-based material in the inner region to the total cross-sectional area of the second silicon-based material in the outer region is (0-30):100, optionally (0-25):100, (0-20):100, (0-15):100, (0-10):100, and (0-5):100. In some embodiments, ratio α2 of the total cross-sectional area of the second silicon-based material in the inner region to the total cross-sectional area of the second silicon-based material in the outer region is 0, that is, the above-mentioned inner region of the negative electrode active material does not contain the second silicon-based material with a relatively small grain size.

By making the second silicon-based material mainly located in the outer region of the negative electrode active material, the effect of the second silicon-based material on improving the cycle performance and reducing the volume expansion can be fully exerted.

In some embodiments, in the outer region of the cross-sectional image of the negative electrode active material, a ratio β1 of the total cross-sectional area of the first silicon-based material to the total cross-sectional area of the second silicon-based material is (0-25):100, optionally (0-20): 100, (0-15): 100, (0-10): 100, (0-5):100, and more optionally the total cross-sectional area of the first silicon-based material is 0, that is, the above-mentioned outer region of the negative electrode active material does not contain the first silicon-based material with a relatively large grain size. The outer region of the negative electrode active material mainly contains the second silicon-based material with a relatively small grain size and does not contain or contains a small amount of the first silicon-based material with a relatively large grain size. As a result, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted.

In some embodiments, in the inner region of the cross-sectional image of the negative electrode active material, a ratio β2 of the total cross-sectional area of the first silicon-based material to the total cross-sectional area of the second silicon-based material is 100:(0-250), optionally 100:(0-100), 100:(0-80), 100:(0-60), 100:(0-40), 100:(0-30), 100:(0-20), 100:(0-10), 100:(0-5). The inner region of the negative electrode active material may only contain the first silicon-based material with a relatively large grain size, or may simultaneously contain a mixture of the first silicon-based material with a relatively large grain size and the second silicon-based material with a relatively small grain size, and by further adjusting the total cross-sectional area of the first silicon-based material and the total cross-sectional area of the second silicon-based material within an appropriate range, the improvement effect of the first silicon-based material on the First Coulombic Efficiency can be better exerted.

In some embodiments, in the cross-sectional image of the negative electrode active material, the ratio γ1 of the total cross-sectional area of the first silicon-based material to the total cross-sectional area of the negative electrode active material is greater than 0 and less than or equal to 25%, for example, it may be 5%, 6%, 7%, 8%, 9%, 10%, 11%, 12%, 13%, 14%, 15%, 16%, 17 %, 18%, 19%, 20%, 21%, 22%, 23%, 24%, 25% or in the ranges formed from any of the above values. Optionally, the ratio γ1 of the total cross-sectional area of the first silicon-based material to the total cross-sectional area of the negative electrode active material is from 5% to 20%, from 8% to 20%, from 10% to 20%, from 12% to 20%, and from 12% to 18%.

When the total cross-sectional area of the first silicon-based material is within the above ranges, not only the improvement effect of the first silicon-based material on the First Coulombic Efficiency can be fully exerted, and but also a relatively large adverse effect on the cycle performance and storage performance of the secondary battery can be avoided.

In some embodiments, in the cross-sectional image of the negative electrode active material, a ratio γ2 of the total cross-sectional area of the second silicon-based material to the total cross-sectional area of the negative electrode active material is greater than or equal to 35% and less than 100%, optionally from 40% to 65%, from 40% to 60%, from 40% to 55%, or from 40% to 50%.

When the total cross-sectional area of the second silicon-based material is within the above-mentioned ranges, not only the improvement effect of the second silicon-based material on the cycle performance and reduction effect of the volume expansion can be fully exerted, and but also a relatively large adverse effect of the second silicon-based material on the First Coulombic Efficiency of the secondary battery can be avoided.

In some embodiments, the mass percentage amount of the first silicon-based material in the silicon-based material is greater than 0 wt% and less than or equal to 40 wt%, for example, it may be in the range of 5 wt%, 10 wt%, 15 wt%, 20 wt%, 25 wt%, 30 wt%, 35 wt%, 40 wt% or in the ranges formed from any of the above values. Optionally, the mass percentage amount of the first silicon-based material in the silicon-based material is from 5 wt% to 40wt%, from 5 wt% to 35 wt%, from 10 wt% to 35 wt%, or from 10 wt% to 30wt%.

When the amount of the first silicon-based material is within the above ranges, not only the improvement effect of the first silicon-based material on the First Coulombic Efficiency can be fully exerted, and but also a relatively large adverse effect of the first silicon-based material on the cycle performance and storage performance of the secondary battery can be avoided.

In some embodiments, at least a part of the silicon-based material is located in the pore structures of the matrix material, and there is/are internal void(s) between the silicon-based material and the matrix material. When there is/are internal void(s) between the silicon-based material and the matrix material, this part of the internal void(s) can serve as a space for accommodating the volume expansion of the silicon-based material, and buffer the stress generated during the expansion process of the silicon-based material.

In some embodiments, the first silicon-based material comprises one or more of elemental silicon, silicon oxide, silicon-carbon material, silicon-nitrogen composite, and silicon alloy, optionally comprises elemental silicon.

In some embodiments, the second silicon-based material comprises one or more of elemental silicon, silicon oxide, silicon-carbon material, silicon-nitrogen composite, and silicon alloy, optionally comprises elemental silicon.

In some embodiments, the materials of the first silicon-based material and the second silicon-based material are the same, and optionally, both the first silicon-based material and the second silicon-based material are elemental silicon.

In some embodiments, the first silicon-based material comprises elemental silicon, and the first silicon-based material has a grain size of greater than 0 nm and less than or equal to 8 nm, for example, it may be in the range of 2 nm, 3 nm, 4 nm, 5 nm, 6 nm, 7 nm, 8 nm or in the ranges formed from any of the above values. Optionally, the grain size of the first silicon-based material is from 2 nm to 8 nm. When the first silicon-based material has an appropriate grain size, the First Coulombic Efficiency of the secondary battery can be improved, and at the same time, a relatively large adverse effect on the cycle performance and storage performance of the secondary battery can be avoided; in addition, it also helps to improve the specific capacity of the negative electrode active material.

In some embodiments, the second silicon-based material comprises elemental silicon, and the second silicon-based material has a grain size of greater than 0 nm and less than or equal to 5 nm, for example, it may be in the range of 1 nm, 2 nm, 2.5 nm, 3 nm, 3.5 nm, 4 nm, 4.5 nm, 5 nm or in the ranges formed from any of the above values. Optionally, the grain size of the second silicon-based material is from 1 nm to 5 nm. When the second silicon-based material has an appropriate grain size, it can not only improve the cycle performance and storage performance of the secondary battery, but also ensure that the secondary battery has a relatively high First Coulombic Efficiency; in addition, it also helps to improve the specific capacity of the negative electrode active material.

In some embodiments, the silicon-based material comprises a vapor-deposited silicon-based material, optionally comprises vapor-deposited elemental silicon.

The matrix material includes a plurality of pore structures, and at least a part of the silicon-based material is located in the pore structures of the matrix material. As a result, the matrix material can effectively relieve the volume expansion of the silicon-based material and prevent the silicon-based material or negative electrode active material from breakage and pulverization.

In some embodiments, the matrix material has a porosity of from 30% to 60%, for example, it may be 30%, 35%, 40%, 45%, 50%, 55%, 60% or in the ranges formed from any of the above values. Optionally, the porosity of the matrix material is from 40% to 50%.

When the porosity of the matrix material is within the above ranges, it is beneficial to accommodating sufficient silicon-based materials, which in turn is beneficial to increasing the energy density of the secondary battery.

In some embodiments, the matrix material comprises one or more of carbon material, graphite material and transition metal oxide material. These matrix materials all include a plurality of pore structures, which can relieve the volume expansion of the silicon-based material and can also improve the conductivity of the silicon-based material.

In some embodiments, the matrix material comprises transition metal oxide material. The pore structures of the transition metal oxide material are controllable and adjustable, and the pore size is more uniform, which is conducive to the uniform dispersion of silicon-based material. Optionally, the molecular formula of the transition metal oxide is MₓO_{y}, 0<x≤2, 0<y≤3, M comprises one or more elements selected from Ni, Co, Mn, Ti and Cu. For example, the transition metal oxide comprises one or more of NiO, Ni₂O₃, CoO, Co₂O₃, MnO, Mn₂O₃, TiO, TiO₂, Ti₂O₃, Cu, Cu₂O and CuO.

In some embodiments, the matrix material comprises graphite material, such as natural graphite. As a result, in addition to alleviating the volume expansion of the silicon-based material and improving the conductivity of the silicon-based material, it can also promote the transmission of active ions and increase the specific capacity of the negative electrode active material.

In some embodiments, the matrix material comprises a carbon material, and the carbon material comprises one or more of activated carbon, biomass carbon, pyrolytic carbon and resin carbon. As a result, in addition to alleviating the volume expansion of the silicon-based material and improving the conductivity of the silicon-based material, it can also promote the transmission of active ions and increase the specific capacity of the negative electrode active material. Moreover, compared with graphite materials, the porous structure of carbon materials is more uniform, thereby also facilitating the dispersion of silicon-based material.

In some embodiments, the negative electrode active material further comprises a coating layer which is located on at least part of surface of the matrix material. By using the coating layer located on the outside of the negative electrode active material, it can further prevent a direct contact between the silicon-based material and an electrolyte, and reduce the reactivity of the silicon-based material after contact with air, thereby reducing side reaction of the electrolyte and reducing the consumption of active ions and improving the cycle performance of the secondary battery. In addition, the coating layer can also provide an effect of buffering the volume expansion of the silicon-based material, which further improves the storage performance of the secondary battery.

In some embodiments, the coating layer comprises one or more of carbon materials, conductive polymers, metal oxides and metal sulfides.

In some embodiments, the carbon material comprises one or more of hard carbon, soft carbon, graphene, carbon fiber, and carbon nanotube.

In some embodiments, the conductive polymer comprises one or more of polyaniline, polypyrrole, and polythiophene.

In some embodiments, the metal oxide comprises one or more of iron oxide, zinc oxide, tin oxide, copper oxide and titanium oxide.

In some embodiments, the metal sulfide comprises one or more of tin sulfide, molybdenum sulfide, titanium sulfide, iron sulfide and copper sulfide.

In some embodiments, the coating layer comprises carbon material, and optionally, the carbon material comprises one or more of hard carbon, soft carbon, graphene, carbon fiber, and carbon nanotube. Therefore, in addition to preventing the silicon-based material from being in direct contact with the electrolyte and buffering the volume expansion of the silicon-based material, the coating layer may also contribute part of the capacity to increase the specific capacity of the negative electrode active material. Additionally, when the coating layer comprises carbon material, it further helps to improve the conductivity of the silicon-based material.

In some embodiments, the coating layer has a thickness of from 0 nm to 200 nm, optionally from 10 nm to 200 nm, from 10 nm to 180 nm, and from 10 nm to 150 nm. When the thickness of the coating layer is within the above ranges, it is beneficial for the negative electrode active material to having high specific capacity and low volume expansion. In the present application, when the thickness of the coating layer is 0 nm, it means that the negative electrode active material does not have a coating layer.

In some embodiments, the negative electrode active material comprises carbon element and silicon element.

In some embodiments, the mass percentage amount of carbon element in the negative electrode active material is from 40 wt% to 60 wt%, such as 40 wt%, 42 wt%, 44 wt%, 46 wt%, 48 wt%, 50 wt%, 52 wt%, 54 wt%, 56 wt%, 58 wt%, 60 wt% or in the ranges formed from any of the above values. Preferably, the mass percentage amount of carbon element in the negative electrode active material is from 45 wt% to 50 wt%.

In some embodiments, the mass percentage amount of silicon element in the silicon-based material is from 38 wt% to 58 wt%, such as 40 wt%, 42 wt%, 44 wt%, 46 wt%, 48 wt%, 50 wt%, 52 wt%, 54 wt%, 56 wt%, 58 wt% or in the ranges formed from any of the above values. Preferably, the mass percentage amount of silicon element in the negative electrode active material is from 40 wt% to 55 wt%.

When the amount of carbon element and/or the amount of silicon element in the negative electrode active material is within the above range, it is beneficial for the negative electrode active material to having both high specific capacity and high conductivity.

The amount of carbon element in the negative electrode active material may be tested with reference to GB/T 20123-2006/ISO 15350:2000, and the test instrument may be an HCS-140 infrared carbon-sulfur analyzer. The amount of silicon element in the negative electrode active material may be tested with reference to GB/T 20975.5-2020.

In some embodiments, the negative electrode active material further comprises other element(s) besides carbon and silicon, and the other elements comprises one or more of oxygen element, metal element and nitrogen element. The distribution area of the other element(s) is not specifically limited, for example, it may be located in at least one of the coating layer, the silicon-based material and the matrix material.

In some embodiments, optionally, a sum of mass percentage amount(s) of other element(s) in the negative electrode active material is from 0 wt% to 20 wt%, optionally from 0 wt% 10 wt% and from 0 wt% 5 wt%. In the present application, when the sum of mass percentage amount(s) of other element(s) in the negative electrode active material is 0 wt%, it means that the negative electrode active material does not comprise other elements except carbon and silicon.

In some embodiments, the negative electrode active material has a pore volume of from 0.001 cm³/g to 0.02 cm³/g, optionally from 0.01 cm³/g to 0.02 cm³/g. When the pore volume of the negative electrode active material is within the above ranges, the internal void(s) of the negative electrode active material is/are in an appropriate range, which on the one hand can improve the specific capacity and the First Coulombic Efficiency of the negative electrode active material, and on the other hand can buffer the stress generated during the expansion process of the silicon-based material.

In this application, the pore volume of the negative electrode active material has well-known meaning in the art, and may be measured with well-known instruments and methods in the art. For example, it may be tested with reference to GB/T 21650.2-2008. The testing instrument may be a TRISTAR II 3020 specific surface area and porosity analyzer from Micromeritics, USA.

In some embodiments, the negative electrode active material has an average particle size Dv50 of from 4 µm to 12 µm. When the average particle size Dv50 of the negative electrode active material is within the above range, it helps to reduce surface activity, reduce interfacial side reactions, reduce the consumption for SEI film formation, and also helps to improve active ion and electron transmission performance, thereby further improving the cycle performance of the secondary battery.

In this application, the average particle size Dv50 of the negative electrode active material has well-known meaning in the art, means the corresponding particle size when the cumulative volume distribution percentage of the material reaches 50%, and may be measured with well-known instruments and methods in the art. For example, it may be conveniently measured by using a laser particle size analyzer with reference to GB/T 19077-2016. The testing instrument may be a Mastersizer 3000 laser particle size analyzer from Malvern Instruments Co., Ltd., UK.

In some embodiments, the negative electrode active material has a BET specific surface area of from 1 m²/g to 15 m²/g. When the BET specific surface area of the negative electrode active material is within the above range, it helps to reduce surface activity, reduce interfacial side reactions, reduce the consumption for SEI film formation, and improve the First Coulombic Efficiency and cycle performance of the secondary battery.

In this application, the BET specific surface area of the negative electrode active material has well-known meaning in the art, and may be measured with well-known instruments and methods in the art. For example, a test method with analysis of specific surface area by nitrogen adsorption may be used for testing, referring to GB/T 19587-2017, and the specific surface area can be calculated by the BET (Brunauer Emmett Teller) method, wherein the test method with analysis of specific surface area by nitrogen adsorption may be carried out by using the TRISTAR II 3020 type specific surface area and porosity analyzer from Micromeritics in the United States.

### Preparation methods

A second aspect of the present application provides a method for preparation of a negative electrode active material, which is capable of preparing the negative electrode active material of the first aspect of the embodiments of the present application.

The method comprises the steps of: providing a matrix material comprising a plurality of pore structures; dispersing a silicon-based material into the pore structures of the matrix material to obtain a negative electrode active material, wherein the negative electrode active material comprises a matrix material and a silicon-based material, the matrix material comprises a plurality of pore structures, and at least a part of the silicon-based material is located in pore structures of the matrix material, at least a part of the silicon-based material has a crystalline structure, the silicon-based material comprises a first silicon-based material and a second silicon-based material with different grain sizes, and a ratio of grain size of the first silicon-based material to grain size of the second silicon-based material is 1.6-4:1.

In some embodiments, the matrix material has a porosity of from 30% to 60%, optionally from 40% to 50%. When the porosity of the matrix material is within the above ranges, it is beneficial to proceeding smoothly the deposition process, and it is also beneficial for the negative electrode active material to having a suitable content of silicon element, a suitable specific surface area and/or a suitable pore volume. When the porosity of the matrix material is too small, part of the silicon-based material is easy to deposit on the surface of the matrix material, which affects the First Coulombic Efficiency of the negative electrode active material; when the porosity of the matrix material is too high, it would easily lead to a problem of insufficient deposition of silicon-based materials and thus an excessive specific surface area of the negative electrode active material, which will increase interfacial side reactions, increase irreversible consumption of active ions, and reduce the First Coulombic Efficiency of the negative electrode active material.

In some embodiments, the matrix material has an average particle size Dv50 of from 4 µm to 12 µm. When the average particle size Dv50 of the matrix material is within the above range, it is beneficial to proceeding smoothly the deposition process, and it is also beneficial for the negative electrode active material to having a suitable content of silicon element, a suitable specific surface area and/or a suitable pore volume. When the average particle size Dv50 of the matrix material is too small, the silicon-based material has a poor deposition effect, which is not conducive to the subsequent two-stage deposition; when the average particle size Dv50 of the matrix material is too high, it would easily lead to a problem of insufficient deposition of silicon-based materials and thus an excessive specific surface area of the negative electrode active material, which will increase interfacial side reactions, increase irreversible consumption of active ions, and reduce the First Coulombic Efficiency of the negative electrode active material.

In some embodiments, the matrix material comprises one or more of carbon material, graphite material and transition metal oxide material.

In some embodiments, the matrix material comprises a carbon material, and the carbon material comprises one or more of activated carbon, biomass carbon, pyrolytic carbon and resin carbon.

In the present application, the matrix material is commercially available, or prepared according to methods known in the art, for example, it may be obtained by high-temperature pyrolysis of organic carbon sources or chemical activation treatment. The organic carbon source may comprise one or more of biomass materials and polymer materials. The chemical activation treatment can be carried out by using a pore-forming agent (such as an alkaline solution) to create pores on a matrix material (such as a carbon material).

The step of dispersing the silicon-based material into the pore structures of the matrix material comprises the following steps of: placing the matrix material comprising a plurality of pore structures as a substrate in a reaction furnace, and feeding a first mixture gas comprising silicon source gas and depositing at a first temperature T₁ for a first time t₁, stopping feeding of the first mixture gas at the end of depositing; when the temperature in the furnace drops to the second temperature T₂, feeding a second mixture gas comprising silicon source gas, and depositing at a second temperature T₂ for a second time t₂, and after the end of depositing, a negative electrode active material is obtained, wherein a region formed by extending from outer surface of particle of the negative electrode active material to inside of the particle by a distance of 0.5 times a length between any point on the outer surface of the particle of the negative electrode active material and a core of the particle is recorded as an outer region, and a region inside the outer region is recorded as an inner region, and in cross-sectional image of the negative electrode active material, total cross-sectional area of the first silicon-based material in the outer region is smaller than total cross-sectional area of the first silicon-based material in the inner region; and total cross-sectional area of the second silicon-based material in the inner region is smaller than total cross-sectional area of the second silicon-based material in the outer region.

In some embodiments, the process for dispersing the silicon-based material into the pore structures of the matrix material is a vapor deposition process, wherein the vapor deposition process comprises a chemical vapor deposition process and/or a physical vapor deposition process, optionally a chemical vapor deposition process, for example, being any one of thermal chemical vapor deposition process, plasma enhanced chemical vapor deposition process, and microwave plasma assisted chemical vapor deposition process.

In some embodiments, the reaction furnace includes, but is not limited to, any one of a deposition furnace, a rotary furnace, a tube furnace, and a fluidized bed.

This application uses a two-stage vapor deposition process to deposit the first silicon-based material and the second silicon-based material in the pore structures of the matrix material. Compared with the conventional liquid-phase deposition process, the vapor-phase deposition process is beneficial to better deposition and uniform dispersion of the silicon-based material in the pore structures of the matrix material, and can avoid the problem of agglomeration and/or large amounts of deposition of silicon-based materials on the surface of the matrix material.

In some embodiments, the method further comprises the steps of: before feeding the first mixture gas comprising silicon source gas, placing the matrix material comprising a plurality of pore structures as a substrate some reaction furnace, and purging with a protective gas for purge treatment and pre-heating treatment, optionally, the temperature for pre-heating is from 200°C to 300°C. This facilitates the removal of residual moisture in the matrix material, and further facilitates subsequent deposition to form the first silicon-based material with a relatively large grain size.

In some embodiments, in the step of dispersing the silicon-based material into the pore structures of the matrix material, a volume percentage V₁ of the silicon source gas in the first mixture gas is greater than a volume percentage V₂ of the silicon source gas in the second mixture gas. As a result, this helps to adjust the distribution area of the first silicon-based material and the second silicon-based material so that the first silicon-based material is mainly located in the inner region of the negative electrode active material and the second silicon-based is mainly located in the outer region of the negative electrode active material. As a result, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted.

In some embodiments, in the step of dispersing the silicon-based material into the pore structures of the matrix material, T₁>T₂.

In some embodiments, in the step of dispersing the silicon-based material into the pore structures of the matrix material, t₁<t₂.

In some embodiments, in the step of dispersing the silicon-based material into the pore structures of the matrix material, T₁>T₂ and t₁<t₂.

In the step of dispersing the silicon-based material into the pore structures of the matrix material, by adjusting the first temperature during deposition to be greater than the second temperature, it is beneficial to adjusting the distribution area of the first silicon-based material and the second silicon-based material so that the first silicon-based material is mainly located in the inner region of the negative electrode active material and the second silicon-based is mainly located in the outer region of the negative electrode active material. As a result, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted.

By adjusting the first time during deposition to be shorter than the second time, it is beneficial to adjusting the amount and distribution area of the first silicon-based material.

In some embodiments, the pressure in the furnace can be adjusted to a slight positive pressure after feeding the first mixture gas containing silicon source gas, for example, it may be 200 Pa-600 Pa higher than the atmospheric pressure, thereby facilitating the smooth progress of deposition.

In some embodiments, the first mixture gas comprises a silicon source gas and a protective gas, and optionally, the volume percentage V₁ of the silicon source gas in the first mixture gas is from 10% to 50%, for example, it may be 10%, 15%, 20%, 25%, 30%, 35%, 40%, 45%, 50% or in the ranges formed from any of the above values.

In some embodiments, the first mixture gas has a total gas flow rate of from 0.5 L/min to 20 L/min. For example, it may be 1 L/min, 2 L/min, 3 L/min, 4 L/min, 5 L/min, 6 L/min, 7 L/min, 8 L/min, 9 L/min, 10 L/min, 12 L/min, 14 L/min, 16 L/min, 18 L/min, 20 L/min or in the ranges formed from any of the above values.

In some embodiments, the first temperature T₁ is from 500°C to 700°C, for example, it may be 520°C, 540°C, 560°C, 580°C, 600°C, 620°C, 640°C, 660°C, 680°C, 700°C or in the ranges formed from any of the above values.

In some embodiments, the first time t₁ is from 0.5 h to 8 h, for example, it may be 1 h, 2 h, 3 h, 4 h, 5 h, 6 h, 7 h, 8 h or in the ranges formed from any of the above values. Optionally, the first time t₁ is from 0.5 h to 4 h.

By adjusting at least one of the composition of the first mixture gas, the total gas flow rate of the first mixture gas, the first temperature, and the first time within the above ranges, it is beneficial to forming the first silicon-based material with a relatively large grain size, and it is also beneficial to adjusting parameters such as distribution area and deposition amount of the first silicon-based material.

When the volume percentage of the silicon source gas in the first mixture gas is too high and/or the total gas flow rate of the first mixture gas is too high, the amount and distribution area of the first silicon-based material increase, thereby adversely affecting the improvement of cycle performance and storage performance of the secondary battery. When the volume percentage of the silicon source gas in the first mixture gas is too low and/or the total gas flow rate of the first mixture gas is too low, the deposition amount of the first silicon-based material may be insufficient, thereby adversely affecting the improvement of the First Coulombic Efficiency of the secondary battery. When the first temperature is too low, it is not conducive to the formation of the first silicon-based material with a large grain size, thereby adversely affecting the improvement of the First Coulombic Efficiency of the secondary battery. When the first temperature is too high, the grain size of the silicon-based material increases, thereby adversely affecting the improvement of the improvement of the cycle performance and storage performance of the secondary battery. When the first time is too short, the deposition amount of the first silicon-based material may be insufficient, thereby adversely affecting the improvement of the First Coulombic Efficiency of the secondary battery. When the first time is too long, the amount and distribution area of the first silicon-based material increase, thereby adversely affecting the improvement of the cycle performance and storage performance of the secondary battery.

In some embodiments, the pressure in the furnace can be adjusted to a slight positive pressure after feeding the second mixture gas containing silicon source gas, for example, it may be 200 Pa-600 Pa higher than the atmospheric pressure, thereby facilitating the smooth progress of deposition.

In some embodiments, the second mixture gas comprises a silicon source gas and a protective gas, and optionally, the volume percentage V₂ of the silicon source gas in the second mixture gas is from 10% to 25%, for example, it may be 10%, 12%, 14%, 16%, 18%, 20%, 22%, 24% or in the ranges formed from any of the above values.

In some embodiments, the second mixture gas has a total gas flow rate of from 0.5 L/min to 20 L/min. For example, it may be 1 L/min, 2 L/min, 3 L/min, 4 L/min, 5 L/min, 6 L/min, 7 L/min, 8 L/min, 9 L/min, 10 L/min, 12 L/min, 14 L/min, 16 L/min, 18 L/min, 20 L/min or in the ranges formed from any of the above values.

In some embodiments, the second temperature T₂ is from 500°C to 600°C, for example, it may be 500°C, 510°C, 520°C, 530°C, 540°C, 550°C, 560°C, 570°C, 580°C, 590°C, 600°C or in the ranges formed from any of the above values.

In some embodiments, the second time t₂ is from 4 h to 20 h, for example, it may be 4 h, 5 h, 6 h, 7 h, 8 h, 9 h, 10 h, 11 h, 12 h, 13 h, 14 h, 15 h, 16 h, 18 h, 20 h or in the ranges formed from any of the above values. Optionally, the second time t₂ is from 4 h to 16 h.

By adjusting at least one of the composition of the second mixture gas, the total gas flow rate of the second mixture gas, the second temperature, and the second time within the above ranges, it is beneficial to forming the second silicon-based material with a relatively small grain size, and it is also beneficial to adjusting parameters such as distribution area and deposition amount of the second silicon-based material.

When the volume percentage of the silicon source gas in the second mixture gas is too high and/or the total gas flow rate of the second mixture gas is too high, the second silicon-based material may be deposited on the surface of the matrix material, which may increase the difficulty in the preparation of the negative electrode slurry and may also increase interfacial side reactions and irreversible consumption of active ions. When the volume percentage of the silicon source gas in the second mixture gas is too low and/or the total gas flow rate of the second mixture gas is too low, the deposition amount of the second silicon-based material may be insufficient, resulting in a relatively large specific surface area of the negative electrode active material, increased interfacial side reactions, an increased irreversible consumption of active ions, and a decreased First Coulombic Efficiency. When the second temperature is too low, it is not conducive to the formation of a crystalline second silicon-based material. When the second temperature is too high, it is easy to form a silicon-based material with a relatively large grain size in the outer region of the matrix material, thereby adversely affecting the improvement of the First Coulombic Efficiency of the secondary battery. When the second time is too short, the deposition amount of the second silicon-based material may be insufficient, resulting in a relatively large specific surface area of the negative electrode active material, increased interfacial side reactions, an increased irreversible consumption of active ions, and a reduced First Coulombic Efficiency. When the second time is too long, the second silicon-based material may be deposited on the surface of the matrix material, which may increase the difficulty in the preparation of the negative electrode slurry and may also increase interfacial side reactions and irreversible consumption of active ions.

In some embodiments, the total gas flow rate of the second mixture gas may be the same as that of the first mixture gas.

In some embodiments, the method also comprises the following step of: forming a coating layer on at least part of surface of the obtained negative electrode active material, and the coating layer comprises one or more of carbon materials, conductive polymers, metal oxides and metal sulfides.

The method for forming a coating layer on at least part of the surface of the obtained negative electrode active material is not specifically limited, and may be selected depending on the composition of the coating layer, for example, any one of solid phase coating, liquid phase coating or gas phase coating may be used.

In some embodiments, the step of forming the coating layer comprises the following steps of: mixing the obtained negative electrode active material with the coating material and then performing carbonization treatment. Optionally, the coating material comprises one or more of asphalt (such as coal tar pitch, petroleum pitch, etc.) and polymer materials. Optionally, the temperature of the carbonization treatment is from 500°C to 1000°C.

In some embodiments, the step of forming a coating layer comprising the following steps of: placing the obtained negative electrode active material in a reaction furnace, feeding the third mixture gas containing carbon source gas, and depositing at a third temperature T₃ for a third time t₃, to obtain a carbon-coated negative electrode active material. This facilitates the formation of a uniform carbon layer.

In some embodiments, the third mixture gas comprises a carbon source gas and a protective gas, and optionally, the volume percentage V₃ of the carbon source gas in the third mixture gas is from 10% to 50%, for example, it may be 10%, 15%, 20%, 25%, 30%, 35%, 40%, 45%, 50% or in the ranges formed from any of the above values.

In some embodiments, the third mixture gas has a total gas flow rate of from 0.5 L/min to 20 L/min. For example, it may be 1 L/min, 2 L/min, 3 L/min, 4 L/min, 5 L/min, 6 L/min, 7 L/min, 8 L/min, 9 L/min, 10 L/min, 12 L/min, 14 L/min, 16 L/min, 18 L/min, 20 L/min or in the ranges formed from any of the above values.

In some embodiments, the third temperature T₃ is from 600°C to 800°C, for example, it may be 600°C, 610°C, 620°C, 630°C, 640°C, 650°C, 660°C, 670°C, 680°C, 700°C, 710°C, 720°C, 730°C, 740°C, 750°C, 760°C, 770°C, 780°C, 790°C, 800°C or in the ranges formed from any of the above values.

In some embodiments, the third time t₃ is from 0.5 h to 4 h, for example, it may be 0.5 h, 1 h, 1.5 h, 2 h, 2.5 h, 3 h, 3.5 h, 4 h or in the ranges formed from any of the above values.

By adjusting at least one of the composition of the third mixture gas, the total gas flow rate of the third mixture gas, the third temperature, and the third time within the above ranges, it is beneficial to forming a coating layer having a suitable thickness and avoiding a coating layer having an excessive thickness which may reduce the First Coulombic Efficiency and/or specific capacity of the negative electrode active material.

In this application, the term "protective gas" includes nitrogen and noble gases, and the noble gases may include one or more of argon, helium, and the like.

In this application, the term "silicon source gas" refers to a gas capable of forming the silicon-based material in this application. Optionally, the silicon source gas includes but is not limited to one or more of silane (H₄Si), ethylsilane (H₆Si₂), propylsilane (H₈Si₃), silicon tetrachloride (Cl₄Si), trichlorosilane (Cl₃HSi), dichlorosilane (Cl₂H₂Si), chlorosilane (ClH₃Si), silicon tetrafluoride (F₄Si), trifluorosilane (F₃HSi), difluorosilane (F₂H₂Si), fluorosilane (FH₃Si), hexachlorodisilane (Cl₆Si₂), pentachlorodisilane (Cl₅HSi₂), tetrachlorodisilane (Cl₄H₂Si₂, including 1,1,2,2-tetrachlorodisilane, 1,1,1,2-tetrachlorodisilane), trichlorodisilane (Cl₃H₃Si₂, including 1,1,2-trichlorodisilane, 1,1,1-trichlorodisilane), dichlorodisilane (Cl₂H₄Si₂, including 1,1-dichlorodisilane, 1,2-dichlorodisilane), monochlorodisilane (ClH₅Si₂), hexafluoride Disilane (F₆Si₂), pentafluorodisilane (F₅HSi₂), 1,1,2,2-tetrafluorodisilane (F₄H₂Si₂), 1,1,1-trifluorodisilane (F₃H₃Si₂), difluorodisilane (F₂H₄Si₂, including 1,1-difluorodisilane, 1,2-difluorodisilane), monofluorodisilane (FH₅Si₂), methylsilane, ethylsilane, dimethylsilane, trimethylsilane, tetramethylsilane, methyldisilane, dimethyldisilane, trimethyldisilane, tetramethyldisilane, hexamethylsilane alkane, methyl trichlorosilane, methyl chlorosilane, chloroethyl silane, dichloro dimethylsilane and dichloro diethylsilane.

In this application, "carbon source gas" refers to a gas capable of forming carbon materials. Optionally, the carbon source gas includes but is not limited to one or more of methane, ethane, propane, isopropane, butane, isobutane, ethylene, propylene, butene, acetylene, ethyl chloride, fluoroethane, difluoroethane, chloromethane, fluoromethane, difluoromethane, trifluoromethane, chloroethylene, fluoroethylene, difluoroethylene, methylamine, formaldehyde, benzene, toluene, xylene, styrene and phenol.

Unless otherwise specified, raw materials and the instruments used in the preparation method of the present application are commercially available.

### Secondary Battery

The third aspect of embodiments of the present application provides a secondary battery.

The secondary battery mentioned in the embodiments of the present application refers to a single physical module including one or more battery cells to provide higher voltage and capacity. For example, the secondary battery mentioned in this application may include a battery cell, a battery module, or a battery pack. A battery cell is the smallest unit constituting a secondary battery, and it alone can realize the function of charging and discharging. The present application does not have particular limitation on the shape of the battery cell, which may be cylindrical, square, or in other arbitrary shapes. Fig. 2 shows a battery cell 5 with a rectangular structure as an example.

In some embodiments, the battery cell includes an electrode assembly and an electrolyte, and the cell may further include an outer packaging. The electrode assembly may be made of positive electrode plate, negative electrode plate, separator, etc. through winding process and/or lamination process, and the outer packaging may be used to package the above electrode assembly. The outer packaging may be a hard package, such as a hard plastic housing, an aluminum housing, steel housing, or the like. The outer packaging may also be a soft package, such as a pouch type soft package. The material of the soft package may be plastic, such as one or more of polypropylene (PP), polybutylene terephthalate (PBT), polybutylene succinate (PBS), and the like.

In some embodiments, referring to Fig. 3, the outer packaging may include a housing 51 and a cover plate 53. The housing 51 may include a bottom plate and side plates connected to the bottom plate, and the bottom plate and the side plate are combined to form an accommodating cavity. The housing 51 has an opening communicating with the accommodating cavity, and the cover plate 53 can cover the opening to close the accommodating cavity. The battery assembly 52 is encapsulated in the accommodating cavity. The number of electrode assemblies 52 included in the battery cell 5 may be one or several, which can be adjusted according to requirements.

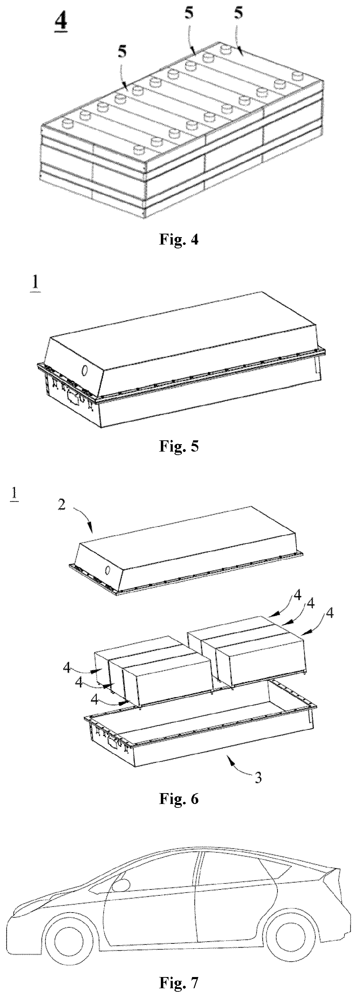

In some embodiments, the battery cell may be assembled into a battery module, the battery module may include a plurality of battery cells, and the specific number can be adjusted according to the application and capacity of the battery module. Fig. 3 is a schematic diagram of a battery module 4 as an example. Referring to Fig. 4, in the battery module 4, a plurality of battery cells 5 may be disposed sequentially in the length direction of the battery module 4. Apparently, they may also be disposed in any other manner. Further, a plurality of battery cells 5 may be fixed by a fastener.

Optionally, the battery module 4 may further include a housing having a receiving space, in which a plurality of battery cells 5 are accommodated.

In some embodiments, the above-mentioned battery module may also be assembled into a battery pack, and the number of battery modules contained in the battery pack can be adjusted according to the application and capacity of the battery pack. Figs. 5 and 6 are schematic diagrams of battery pack 1 as an example. As shown in Figs. 5 and 6, the battery pack 1 may comprise a battery case and a plurality of the battery modules 4 disposed in the battery case. The battery case comprises an upper case body 2 and a lower case body 3. The upper case body 2 is used for covering the lower case body 3 to form a closed space for receiving the battery modules 4. A plurality of battery modules 4 can be disposed in the battery case in any manner.

The present application has no particular limitation on the type of the secondary battery. For example, the secondary battery may include, but not limited to, a lithium ion battery, a sodium ion battery, and the like.

### [Negative electrode plate]

In some embodiments of the disclosure, the negative electrode plate comprises a negative positive electrode current collector and a negative electrode film layer which is disposed on at least one surface of the negative electrode current collector and comprises a negative electrode active material. For example, the negative current collector has two opposite surfaces along the thickness direction of the negative current collector, and the positive electrode film layer is disposed on any one or both of the two opposite surfaces of the negative current collector.

In some embodiments, the negative electrode film layer comprises a negative electrode active material of the first aspect of embodiments of this application or the negative electrode active material prepared by the method of the second aspect of embodiments of this application. As a result, the secondary battery can have high energy density, high First Coulombic Efficiency, long cycle life expansion and long storage life at the same time.

In some embodiments, the negative electrode film layer may further include other negative electrode active materials in addition to the above-mentioned negative electrode active material. In some embodiments, the other negative electrode active materials include but are not limited to one or more of natural graphite, artificial graphite, soft carbon, hard carbon, elemental silicon, silicon oxide, silicon-nitrogen composite, silicon alloy material, elemental tin, tin oxide, tin alloy materials and lithium titanate. The present application is not limited to these materials, but may use other conventionally known materials that can be used as negative electrode active materials for secondary batteries.

In some embodiments, the negative electrode film layer may also optionally comprise a conductive agent for negative electrode. The application has no special restrictions on the type of the conductive agent for negative electrode. As an example, the conductive agent for negative electrode may include one or more of superconducting carbon, conductive graphite, acetylene black, carbon black, Ketjen black, carbon dots, carbon nanotubes, graphene and carbon nanofibers.

In some embodiments, the negative electrode film layer may further optionally comprises a binder for negative electrode. The present application does not particularly limit the type of the binder for negative electrode, and as an example, the binder for negative electrode may include one or more of styrene-butadiene rubber (SBR), water-soluble unsaturated resin SR-1B, aqueous acrylic resins (e.g., polyacrylic acid PAA, polymethacrylic acid PMAA, sodium polyacrylate PAAS), polyacrylamide (PAM), polyvinyl alcohol (PVA), sodium alginate (SA), and carboxymethyl chitosan (CMCS).

In some embodiments, the negative electrode film layer may further optionally comprises other auxiliary agents. As examples, other auxiliary agents may include thickeners, e.g., sodium carboxymethylcellulose (CMC), PTC thermistor material, etc.

In some embodiments, the negative electrode collector may be a metal foil or a composite collector. As an example of a metal foil, a copper foil may be used. The composite current collector may include a base layer of polymeric material and a layer of metallic material formed on at least one surface of the base layer of polymeric material. As an example, the metal material may comprise one or more of copper, copper alloy, nickel, nickel alloy, titanium, titanium alloy, silver, and silver alloy. As an example, the base layer of polymeric material may comprise one or more of polypropylene (PP), polyethylene terephthalate (PET), polybutylene terephthalate (PBT), polystyrene (PS), polyethylene (PE), and the like.

The negative electrode film layer is usually formed by applying a negative electrode slurry on a negative electrode collector, drying and cold-pressing. The negative electrode slurry is typically formed by dispersing the negative electrode active material, optional conductive agent, optional binder, other optional auxiliary agents in a solvent and stirring well. The solvent may be N-methylpyrrolidone (NMP) or deionized water, but is not limited thereto.

The negative electrode plate does not exclude additional functional layers other than the negative electrode film layer. For example, in some embodiments, the negative electrode plate described in the present application may also comprise a conductive primer layer (such as composed of a conductive agent and a binder) sandwiched between the negative electrode current collector and the negative electrode film layer, and arranged on the surface of the negative electrode current collector; in some embodiments, the negative electrode plate described in this application may also comprise a protective layer covering the surface of the negative electrode film layer.

### [Positive electrode plate]

In some embodiments of the disclosure, the positive electrode plate comprises a positive electrode current collector and a positive electrode film layer which is disposed on at least one surface of the positive electrode current collector and comprises a positive electrode active material. For example, the positive current collector has two opposite surfaces along the thickness direction of the positive current collector, and the positive electrode film layer is disposed on any one or both of the two opposite surfaces of the positive current collector.

The positive electrode film layer includes a positive electrode active material, and the positive electrode active material can be a positive electrode active material known in the art for secondary batteries.

When the secondary battery of the present application is a lithium ion battery, the positive electrode active material may comprise one or more of lithium transition metal oxides, lithium-containing phosphates with olivine structure, and their respective modified compounds thereof. Examples of lithium transition metal oxides may comprise one or more of lithium cobalt oxide, lithium nickel oxide, lithium manganese oxide, lithium nickel cobalt oxide, lithium manganese cobalt oxide, lithium nickel manganese oxide, lithium nickel cobalt manganese oxide, lithium nickel cobalt aluminum oxide and their respective modified compounds. Examples of lithium-containing phosphates with olivine structure may comprise one or more of lithium iron phosphate, composite of lithium iron phosphate with carbon, lithium manganese phosphate, composite of lithium manganese phosphate with carbon, lithium manganese iron phosphate, composite of lithium manganese iron phosphate with carbon, and respective modified compounds thereof. The present application is not limited to these materials, but may use other conventionally known materials that can be used as positive electrode active materials for secondary batteries.

In some embodiments, in order to further increase the energy density of the secondary battery, the positive electrode active material for the lithium-ion battery may comprise one or more of lithium transition metal oxides having general formula LiₐNi_{b}Co_{c}M_{d}OₑA_{f} and modified compounds thereof. 0.8≤a≤1.2, 0.5≤b<1, 0<c<1, 0<d<1, 1≤e≤2, 0≤f≤1, M includes one or more of Mn, Al, Zr, Zn, Cu, Cr, Mg, Fe, V, Ti and B, and A includes one or more of N, F, S and Cl.

As an example, positive electrode active materials for lithium-ion batteries may include one or more of LiCoO₂, LiNiO₂, LiMnO₂, LiMn₂O₄, LiNi_{1/3}Co_{1/3}Mn_{1/3}O₂ (NCM333), LiNi_{0.5}Co_{0.2}Mn_{0.3}O₂ (NCM523), LiNi_{0.6}Co_{0.2}Mn_{0.2}O₂ (NCM622), LiNi_{0.8}Co_{0.1}Mn_{0.1}O₂ (NCM811), LiNi_{0.85}Co_{0.15}Al_{0.05}O₂, LiFePO₄and LiMnPO₄.

When the secondary battery of the present application is a sodium ion battery, the positive electrode active material may include but not limited to one or more of sodium-containing transition metal oxides, polyanion materials (such as phosphate, fluorophosphate, pyrophosphate, sulfate, etc.), and Prussian blue materials.

As an example, a positive electrode active material for a sodium-ion battery may include one or more of NaFeO₂, NaCoO₂, NaCrO₂, NaMnO₂, NaNiO₂, NaNi_{1/2}Ti_{1/2}O₀₂, NaNi_{1/2}Mn_{1/2}O₂, Na_{2/3}Fe_{1/3}Mn_{2/3}O₂, NaNi_{1/3}Co_{1/3}Mn_{1/3}O₂, NaFePO₄, NaMnPO₄, NaCoPO₄, Prussian blue material and the materials having the general formula XₚM'_{q}(PO₄)ᵣOₓY₃₋ₓ. In general formula XₚM'_{q}(PO₄)ᵣOₓY₃₋ₓ, 0<p≤4, 0<q≤2, 1≤r≤3, 0≤x≤2, X includes one or more of H⁺, Li⁺, Na⁺, K⁺and NH₄⁺, M' is a transition metal cation, optionally including one or more selected from V, Ti, Mn, Fe, Co, Ni, Cu and Zn, and Y is a halogen anion and optionally comprising one or more selected from F, Cl and Br.

n the present application, the modified compounds of the above positive electrode active materials may be doping-modified and/or surface coating-modified of the positive electrode active materials.

In some embodiments, the positive electrode film layer may also optionally comprise a conductive agent for positive electrode. The application has no special restrictions on the type of the conductive agent for positive electrode. As an example, the conductive agent for positive electrode include one or more of superconducting carbon, conductive graphite, acetylene black, carbon black, Ketjen black, carbon dots, carbon nanotubes, graphene and carbon nanofibers.

In some embodiments, the positive electrode film layer may further optionally comprise a binder for positive electrode. The present application does not particularly limit the type of the binder for positive electrode, and as an example, the binder for positive electrode may comprise one of more of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, vinylidene fluoride-hexafluoropropylene copolymer, and fluorinated acrylate resins.

In some embodiments, the positive electrode current collector may be a metal foil or a composite current collector. As an example of the metal foil, aluminum foil may be used. The composite current collector may include a base layer of polymeric material and a layer of metallic material formed on at least one surface of the base layer of polymeric material. As an example, the metal material may comprise one or more of aluminum, aluminum alloy, nickel, nickel alloy, titanium, titanium alloy, silver, and silver alloy. As an example, the base layer of polymeric material may comprise one or more of polypropylene (PP), polyethylene terephthalate (PET), polybutylene terephthalate (PBT), polystyrene (PS), polyethylene (PE), and the like.

The positive electrode film layer is usually formed by applying a positive electrode slurry on a positive electrode current collector, drying and cold-pressing. The positive electrode slurry is usually formed by dispersing positive electrode active material, an optional conductive agent, an optional binder and any other components in a solvent and stirring them uniformly. The solvent may be N-methylpyrrolidone (NMP), but is not limited thereto.

### [Electrolyte]

The electrolyte provides the function of conducting active ions between the positive electrode plate and the negative electrode plate. There is no specific limitation on the type of electrolyte in the present application, and it can be selected according to the requirement. For example, the electrolyte may comprise one or more of solid electrolyte and liquid electrolyte (i.e., electrolytic solution).

In some embodiments of the disclosure, the electrolyte is an electrolytic solution, and the electrolytic solution includes an electrolyte salt and a solvent.

When the secondary battery of the present application is a lithium ion battery, as an example, the electrolyte salt may comprise one or more of lithium hexafluorophosphate (LiPF₆), lithium tetrafluoroborate (LiBF₄), lithium perchlorate (LiClO₄), lithium hexafluoroarsenate (LiAsF₆), lithium difluorosulfimide (LiFSI), lithium bistrifluoromethanesulfonimide (LiTFSI), lithium trifluoromethanesulfonate (LiTFS), lithium difluorooxalate (LiDFOB), lithium bisoxalate (LiBOB), lithium difluorophosphate (LiPO₂F₂), lithium difluorobisoxalate phosphate (LiDFOP), and lithium tetrafluorooxalate phosphate (LiTFOP).

When the secondary battery of the present application is a sodium ion battery, in particular, when it is a sodium ion secondary battery, the electrolyte salt may comprise one or more of sodium hexafluorophosphate (NaPF₆), sodium tetrafluoroborate (NaBF₄), sodium perchlorate (NaClO₄), sodium hexafluoroarsenate (NaAsF₆), sodium bisfluorosulfonimide (NaFSI), sodium bistrifluoromethanesulfonimide (NaTFSI), sodium trifluoromethanesulfonate (NaTFS), sodium difluorooxalate borate (NaDFOB), sodium dioxalate borate (NaBOB), sodium difluorophosphate (NaPO₂F₂), sodium difluorooxalate phosphate (NaDFOP) and sodium tetrafluorooxalate phosphate (NaTFOP).

There is no specific limitation on the type of solvent, and it can be selected according to actual needs. In some embodiments, as an example, the solvent may comprise one or more of ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate (BC), fluoroethylene carbonate (FEC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), dimethylsulfone (MSM), methylethylsulfone (EMS), and diethylsulfone (ESE).

In some embodiments, the electrolytic solution may optionally comprise an additive. For example, the additives may comprise negative electrode film-forming additives, positive electrode film-forming additives, and additives that can improve certain performance of the battery, such as additives that improve overcharging performance of the battery, additives that improve high-temperature performance of the battery, and additives that improve low-temperature power/rating performance of the battery.

### [Separator]

In secondary batteries that use electrolytic solution, and some secondary batteries that use solid electrolytes, a separator is also included. The separator is arranged between the positive electrode plate and the negative electrode plate and is mainly used to prevent the short circuit between the positive electrode and the negative electrode and at the same time allows active ions to pass through. The type of the separator is not particularly limited in the present application, and any well-known porous structure separator having electrochemical stability and mechanical stability can be selected.

In some embodiments of the disclosure, the separator may comprise one or more of glass fiber, non-woven fabric, polyethylene, polypropylene and polyvinylidene fluoride. The separator can be a single-layer film or a multilayer film. When the separator is a multilayer film, the materials of each layer are the same or different.

### [Preparation]

The preparation method of the secondary battery of the present application is well-known. In some embodiments, a positive electrode plate, a separator, a negative electrode plate, and electrolytic solution can be assembled to form a secondary battery. As an example, the positive electrode plate, the separator, and the negative electrode plate can be formed into an electrode assembly by a winding process and/or a laminating process; the battery assembly is placed in an outer package, into which the electrolytic solution is injected after it is dried. After that, the processes of vacuum packing, steady standing, formation, and shaping are carried out, thereby obtaining a battery cell. A plurality of battery cells may further be connected in series, in parallel or in series-parallel to form a battery module. Then multiple battery modules may also be connected in series, in parallel or in series-parallel to form a box pack. In some embodiments, the multiple battery cells may also be directly assembled into a battery pack.

### Electrical device

The secondary battery may be used as a power source of the electrical device, and may also be used as an energy storage unit of the electrical device. The electrical device may be, but is not limited to, a mobile device (e.g., a mobile phone, a tablet computer, a laptop computer, etc.), an electric vehicle (e.g., a pure electric vehicle, a hybrid electric vehicle, a plug-in hybrid electric vehicle, an electric bicycle, an electric scooter, an electric golf vehicle, an electric truck), an electric train, a ship, a satellite, an energy storage system, etc.

The electrical device may select a specific type of secondary battery according to its usage requirements, such as battery cells, battery modules, or battery packs.

Fig. 7 is a schematic diagrams of an electrical device as an example. The electrical device is a pure electric vehicle, a hybrid electric vehicle, or a plug-in hybrid electric vehicle. In order to meet high power and high energy density requirements of the electrical device, a battery pack or a battery module may be used as a power supply.

As another example, the electrical device may be a mobile phone, a tablet computer, a notebook computer, etc. The electric device is generally required to be light and thin, and a battery cell may be used as a power supply.

### Examples

The following examples are intended to describe the present application more specifically, merely for the purpose of illustration. Various modifications and variations within the scope of the present application are apparent to those skilled in the related art. Unless otherwise stated, all parts, percentages, and ratios reported in the following examples are based on mass, and all reagents used in the examples are commercially available or synthesized by conventional methods, and can be directly obtained without further treatment, and the instruments used in the examples are commercially available.

### Example 1

### (1) Preparation of negative electrode active material

1 kg of commercially available porous biomass carbon with a porosity of 45% was used as the substrate, placed in a vapor deposition furnace, with the rotation rate of the furnace body at 0.5 rpm using argon for purging treatment, and pre-heated to 200 °C. The temperature was increased by continuously heating up to 600°C, and the first mixture gas according to 30% silane + 70% argon (volume ratio) was fed with the total gas flow rate of 2 L/min, and the pressure in the furnace was a slight positive pressure that was 400 Pa higher than atmospheric pressure; and the deposition time was 4 h. The feeding of the first mixture gas was suspended, and when the temperature in the furnace dropped to 550°C, the second mixture gas according to 15% silane + 85% argon (volume ratio) was fed with the total gas flow rate of 2 L/min; and the deposition time was 12h . The second mixture gas was turn off; the temperature was raised to 700°C again, and the third mixture gas according to 20% acetylene + 80% argon (volume ratio) was fed with the total gas flow rate is 2 L/min; the deposition time was 1h; after cooling, discharging and passing through a 325-mesh sieve, the negative electrode active material was obtained.

### (2) Preparation of secondary battery (full battery)

Preparation of the negative electrode plate: the negative electrode active material prepared above, the conductive carbon black and carbon nanotubes as a conductive agent, and the polyacrylic acid as binder were mixed at a mass ratio of 95:1.9:0.1:3, and then added to the deionized water as solvent; the resulting mixture was stirred under the action of a fast mixer until the system was uniform and a negative electrode slurry with a solid content of 45% was obtained; the negative electrode slurry was evenly applied on the copper foil of the negative electrode current collector, dried at 85°C, and cold-pressed to give the negative electrode plate.

Preparation of positive electrode plate: The positive electrode active material LiNi_{0.8}Co_{0.1}Mn_{0.1}O₂ (NCM811), the carbon black (Super P) as conductive agent, and polyvinylidene fluoride (PVDF) as binder were mixed at a mass ratio of 97:1:2 in an appropriate amount of solvent NMP with thorough stirring to form a uniform positive electrode slurry; the positive electrode slurry was uniformly applied on the surface of the aluminum foil of positive electrode collector, and then dried and cold-pressed, to give the positive electrode plate.

Preparation of electrolytic solution: ethylene carbonate (EC), ethyl methyl carbonate (EMC) and diethyl carbonate (DEC) at a volume ratio of 20:20:60 were uniformly mixed as an organic solvent, and then LiPF₆ was dissolved in the above organic solvent, and fluoroethylene carbonate (FEC) was added, with the concentration of LiPF₆ in the electrolytic solution of 1 mol/L and the mass percentage of FEC of 5 wt%.

### Preparation of the separator: Celgard 2400 separator was used.

Preparation of secondary batteries: the positive electrode plate, separator, and negative electrode plate was laminated and coiled in sequence to obtain an electrode assembly; the electrode assembly was placed in an outer packaging and dried, followed by injection with electrolytic solution; after the processes including vacuum encapsulation, standing, formation, shaping, a secondary battery was obtained.

### (3) Preparation of button battery (half cell)

The negative electrode active material prepared above, the conductive carbon black as a conductive agent, and the polyacrylic acid as binder were mixed at a mass ratio of 8:1:1, and then added to the deionized water as solvent; the resulting mixture was stirred under the action of a fast mixer until the system was uniform and a negative electrode slurry with a solid content of 45% was obtained; the negative electrode slurry was evenly applied on the copper foil of the negative electrode current collector, dried at 85°C, and cold-pressed to give an electrode plate. A lithium metal sheet was used as a counter electrode, a Celgard 2400 separator was used, and the same electrolytic solution as that used for the preparation of the secondary battery was injected; after assembling, a button battery is obtained.

### Examples 2-20

The preparation method of the secondary battery and the button battery was similar to that of Example 1, except that the preparation process parameters of the negative electrode active material were adjusted, as shown in Table 1 for details.

### Example 21

The preparation method of the secondary battery and the button battery was similar to that of Example 1, except that the preparation process parameters of the negative electrode active material were adjusted.

1 kg of commercially available porous biomass carbon with a porosity of 45% was used as the substrate, placed in a vapor deposition furnace, with the rotation rate of the furnace body at 0.5 rpm using argon for purging treatment, and pre-heated to 200 °C. The temperature was increased by continuously heating up to 550°C, and the first mixture gas according to 15% silane +85% argon (volume ratio) was fed with the total gas flow rate of 2 L/min, and the pressure in the furnace was a slight positive pressure that was 400 Pa higher than atmospheric pressure; and the deposition time was 12 h. The feeding of the first mixture gas was suspended, and the temperature in the furnace increased to 600°C, the second mixture gas according to 30% silane + 70% argon (volume ratio) was fed with the total gas flow rate of 2 L/min; and the deposition time was 4h. The second mixture gas was turn off; the temperature was raised to 700°C again, and the third mixture gas according to 20% acetylene + 80% argon (volume ratio) was fed with the total gas flow rate is 2 L/min; the deposition time was 1h; after cooling, discharging and passing through a 325-mesh sieve, the negative electrode active material was obtained.

### Comparative Example 1

The preparation method of the secondary battery and the button battery was similar to that of Example 1, except that the preparation process parameters of the negative electrode active material were adjusted.

Crystalline silicon coated with amorphous carbon was used as the negative electrode active material, and the thickness of the coating layer was 300 nm.

### Comparative Example 2

The preparation method of the secondary battery and the button battery was similar to that of Example 1, except that the preparation process parameters of the negative electrode active material were adjusted.

1 kg of commercially available porous biomass carbon with a porosity of 45% was used as the substrate, placed in a vapor deposition furnace, with the rotation rate of the furnace body at 0.5 rpm using argon for purging treatment, and pre-heated to 200 °C. The temperature was increased by continuously heating up to 600°C, and the first mixture gas according to 30% silane +70% argon (volume ratio) was fed with the total gas flow rate of 2 L/min, and the pressure in the furnace was a slight positive pressure that was 400 Pa higher than atmospheric pressure; and the deposition time was 12 h. The first mixture gas was turn off; the temperature was raised to 700°C again, and the second mixture gas according to 20% acetylene + 80% argon (volume ratio) was fed with the total gas flow rate is 2 L/min; the deposition time was 1 h; after cooling, discharging and passing through a 325-mesh sieve, the negative electrode active material was obtained.

### Comparative Example 3

The preparation method of the secondary battery and the button battery was similar to that of Example 1, except that the preparation process parameters of the negative electrode active material were adjusted.

1 kg of commercially available porous biomass carbon with a porosity of 45% was used as the substrate, placed in a vapor deposition furnace, with the rotation rate of the furnace body at 0.5 rpm using argon for purging treatment, and pre-heated to 200 °C. The temperature was increased by continuously heating up to 450°C, and the first mixture gas according to 15% silane + 85% argon (volume ratio) was fed with the total gas flow rate of 2 L/min, and the pressure in the furnace was a slight positive pressure that was 400 Pa higher than atmospheric pressure; and the deposition time was 18 h. The first mixture gas was turn off; the temperature was raised to 700°C again, and the second mixture gas according to 20% acetylene + 80% argon (volume ratio) was fed with the total gas flow rate is 2 L/min; the deposition time was 1 h; after cooling, discharging and passing through a 325-mesh sieve, the negative electrode active material was obtained.

**Table 1**

| No. | Porosity of porous biomass carbon | first deposition | | | second deposition | | | third deposition | | |
|---|---|---|---|---|---|---|---|---|---|---|
| | | first mixture gas (Volume ratio) | Deposition temperature (°C) | Deposition time (h) | second mixture gas (Volume ratio) | Deposition temperature (°C) | Deposition time (h) | third mixture gas (Volume ratio) | Deposition temperature (°C) | Deposition time (h) |
| Example 1 | 45% | silane: Argon = 30:70 | 600 | 2 | silane: Argon = 15:85 | 550 | 12 | Acetylene: Argon = 20:80 | 700 | 1 |
| Example 2 | 45% | silane: Argon = 30:70 | 600 | 2.5 | silane: Argon = 15:85 | 550 | 10 | Acetylene: Argon = 20:80 | 700 | 1 |
| Example 3 | 45% | silane: Argon = 30:70 | 600 | 3 | silane: Argon = 15:85 | 550 | 8 | Acetylene: Argon = 20:80 | 700 | 1 |
| Example 4 | 45% | silane: Argon = 30:70 | 600 | 1.5 | silane: Argon = 15:85 | 550 | 14 | Acetylene: Argon = 20:80 | 700 | 1 |
| Example 5 | 45% | silane: Argon = 30:70 | 600 | 1 | silane: Argon = 15:85 | 550 | 16 | Acetylene: Argon = 20:80 | 700 | 1 |
| Example 6 | 45% | silane: Argon = 30:70 | 600 | 4 | silane: Argon = 15:85 | 550 | 6 | Acetylene: Argon = 20:80 | 700 | 1 |
| Example 7 | 45% | silane: Argon = 30:70 | 700 | 2 | silane: Argon = 15:85 | 600 | 8 | Acetylene: Argon = 20:80 | 700 | 1 |
| Example 8 | 45% | silane: Argon = 30:70 | 650 | 2 | silane: Argon = 15:85 | 570 | 8 | Acetylene: Argon = 20:80 | 700 | 1 |
| Example 9 | 45% | silane: Argon = 30:70 | 550 | 2 | silane: Argon = 15:85 | 540 | 8 | Acetylene: Argon = 20:80 | 700 | 1 |
| Example 10 | 45% | silane: Argon = 30:70 | 500 | 2 | silane: Argon = 15:85 | 500 | 8 | Acetylene: Argon = 20:80 | 700 | 1 |
| Example 11 | 45% | silane: Argon = 30:70 | 600 | 2 | silane: Argon = 15:85 | 550 | 12 | Acetylene: Argon = 40:60 | 700 | 2 |
| Example 12 | 45% | silane: Argon = 30:70 | 600 | 2 | silane: Argon = 15:85 | 550 | 12 | Acetylene: Argon = 40:60 | 700 | 1 |
| Example 13 | 45% | silane: Argon = 30:70 | 600 | 2 | silane: Argon = 15:85 | 550 | 12 | Acetylene: Argon = 30:70 | 700 | 1 |
| Example 14 | 45% | silane: Argon = 30:70 | 600 | 2 | silane: Argon = 15:85 | 550 | 12 | Acetylene: Argon = 10:90 | 650 | 0.5 |
| Example 15 | 45% | silane: Argon = 30:70 | 600 | 2 | silane: Argon = 15:85 | 550 | 12 | Acetylene: Argon = 5:95 | 650 | 0.5 |
| Example 16 | 45% | silane: Argon = 30:70 | 600 | 2 | silane: Argon = 15:85 | 550 | 12 | / | / | / |
| Example 17 | 30% | silane: Argon = 30:70 | 600 | 1 | silane: Argon = 15:85 | 550 | 8 | Acetylene: Argon = 20:80 | 700 | 1 |
| Example 18 | 60% | silane: Argon = 30:70 | 600 | 3 | silane: Argon = 15:85 | 550 | 16 | Acetylene: Argon = 20:80 | 700 | 1 |
| Example 19 | 20% | silane: Argon = 30:70 | 600 | 0.5 | silane: Argon = 15:85 | 550 | 6 | Acetylene: Argon = 20:80 | 700 | 1 |
| Example 20 | 70% | silane: Argon = 30:70 | 600 | 4 | silane: Argon = 15:85 | 550 | 20 | Acetylene: Argon = 20:80 | 700 | 1 |
| Example 21 | 45% | silane: Argon = 15:85 | 550 | 12 | silane: Argon = 30:70 | 600 | 2 | Acetylene: Argon = 20:80 | 700 | 1 |
| Comparative Example 1 | / | / | / | / | / | / | / | / | / | / |
| Comparative Example 2 | 45% | silane: Argon = 30:70 | 600 | 10 | / | / | / | Acetylene: Argon = 20:80 | 700 | 1 |
| Comparative Example 3 | 45% | silane: Argon = 15:85 | 450 | 18 | / | / | / | Acetylene: Argon = 20:80 | 700 | 1 |

### Test section

### (1) Test of grain size

A double-beam focused ion beam microscope is used to intercept a sample from the particle core of the negative electrode active material to obtain a cross-sectional image of the negative electrode active material particle, and then grain size of the crystalline silicon-based material is observed and calculated through a high-resolution transmission electron microscope. In the obtained cross-sectional image, the area with lattice fringe characteristics is regarded as one grain, the diameter of this area is regarded as the grain size, and the average value of at least 50 grain sizes is taken as the test result. When the grain size of the first silicon-based material to be tested, samples may be taken from near the particle core of the negative electrode active material; when the grain size of the second silicon-based material is to be tested, samples may be taken from near the particle surface of the negative electrode active material. Helios 5 CX focused ion beam/scanning electron microscope dual-beam system and Spectra S/TEM scanning transmission electron microscope from Thermo Fisher can be adopted as the testing instrument.

The grain area is calculated with the grain shape being spherical, and the grain size is used as the spherical diameter for calculation.

A region formed by extending from outer surface of particle of the negative electrode active material to inside of the particle by a distance of 0.5 times a length between any point on the outer surface of the particle of the negative electrode active material and a core of the particle is recorded as an outer region, and a region inside the outer region is recorded as an inner region.

The ratio of the total cross-sectional area of the first silicon-based material in the outer region of the above-mentioned cross-sectional image to the total cross-sectional area of the first silicon-based material in the inner region is denoted as α1; the ratio of the second silicon-based material in the inner region of the above-mentioned cross-sectional image to the total cross-sectional area of the second silicon-based material in the outer region to the total cross-sectional area is denoted as α2; the ratio of the total cross-sectional area of the first silicon-based material in the above cross-sectional image to the total cross-sectional area of the negative electrode active material is denoted as γ1; and the ratio of the total cross-sectional area of the second silicon-based material to the total cross-sectional area of the negative electrode active material in the above cross-sectional image is denoted as γ2.

### (2) Test of element amount of negative electrode active material

The amount of carbon element in the negative electrode active material may be tested with reference to GB/T 20123-2006/ISO 15350:2000, and the test instrument can be an HCS-140 infrared carbon-sulfur analyzer.

The amount of silicon in the negative electrode active material is tested referring to GB/T 20975.5-2020.

### (3) Test of average particle size Dv50 of negative electrode active material

With reference to GB/T 19077-2016, the volume particle size distribution curve of the negative electrode active material is obtained, and the corresponding particle size when the cumulative volume distribution percentage reaches 50% is taken as the average particle size Dv50. The testing instrument may be a Mastersizer 3000 laser particle size analyzer from Malvern Instruments Co., Ltd., UK.

### (4) Test of specific surface area of negative electrode active material

A test method with analysis of specific surface area by nitrogen adsorption is used for testing, referring to GB/T 19587-2004, and the specific surface area can be calculated by the BET (Brunauer Emmett Teller) method. The testing instrument may be a TRISTAR II 3020 specific surface area and porosity analyzer from Micromeritics, USA.

### (5) Test of pore volume of negative electrode active material

The pore volume of the negative electrode active material is tested referring to GB/T 21650.2-2008. The testing instrument may be a TRISTAR II 3020 specific surface area and porosity analyzer from Micromeritics, USA.

### (6) Test of First Coulombic Efficiency

After the button cell prepared above is left to stand for 60 minutes, it is discharged to 5 mV at a constant current of 0.05C, and then discharged to 5 mV at 50 µA, and the total discharge capacity of the button cell is recorded as an initial lithium intercalation capacity; after standing for 10 minutes, the button cell is charged to 0.8V at a constant current of 0.1C, and the charging capacity of the button battery is recorded as the initial de-intercalation capacity.

The First Coulombic Efficiency of the negative electrode active material = initial de-intercalation capacity/initial lithium intercalation capacity.

### (7) Test of cycle performance of secondary battery

At 25°C, the secondary battery prepared above is fully charged at 0.5C and then fully discharged at 1C. This is a cyclic charge and discharge process, and the discharge capacity at this time is recorded as the initial discharge capacity. The secondary battery is subjected to tests of cycles of charge and discharge according to the above method, and the discharge capacity for each cycle is recorded until the discharge capacity of the lithium ion battery decays to 80% at which and the number of cycles of the lithium ion battery is recorded. The higher the cycle number of the secondary battery, the better the cycle performance.

### (8) Test of volume expansion of negative electrode plate

At 25°C, after fully charging the secondary battery prepared above at 0.33C, the negative electrode plate is disassembled in a dry room, and the thickness H₁ of the negative electrode plate in the fully charged state is record. The volume expansion rate of the negative electrode plate = (H₁-H₀)/H₀, H₀ represents the initial thickness of the negative electrode plate after cold pressing.

**Table 2**

| No. | Negative electrode active material | | | | | | | | | | battery performance | | | |
|---|---|---|---|---|---|---|---|---|---|---|---|---|---|---|
| | grain size of the first silicon-based material (nm) | grain size of the second silicon-based material (nm) | thickness of coating layer (nm) | amount of carbon (wt%) | amount of silicon (wt%) | γ1 | γ2 | Pore volume (cm³/g) | Dv50 (µm) | Specific surface area (m²/g) | Initial de-intercalation capacity (mAh/g) | First Coulombic Efficiency | volume expansion rate of negative electrode plate | Number of cycles |
| Example 1 | 6 | 3 | 100 | 48 | 49 | 15% | 48% | 0.0150 | 8.0 | 4.5 | 1589 | 85.0% | 42% | 1340 |
| Example 2 | 6 | 3 | 100 | 48 | 49 | 20% | 43% | 0.0150 | 8.0 | 4.5 | 1586 | 85.0% | 46% | 1310 |
| Example 3 | 6 | 3 | 100 | 48 | 49 | 25% | 38% | 0.0160 | 8.0 | 4.2 | 1579 | 85.1% | 48% | 1220 |
| Example 4 | 6 | 3 | 100 | 48 | 49 | 10% | 53% | 0.0140 | 8.0 | 4.4 | 1591 | 84.3% | 40% | 1380 |
| Example 5 | 6 | 3 | 100 | 48 | 49 | 5% | 58% | 0.0130 | 8.0 | 4.7 | 1583 | 84.1% | 38% | 1400 |
| Example 6 | 6 | 3 | 100 | 48 | 49 | 40% | 25% | 0.0150 | 8.0 | 4.1 | 1571 | 85.4% | 60% | 780 |
| Example 7 | 10 | 6 | 100 | 48 | 49 | 15% | 48% | 0.0150 | 8.0 | 4.6 | 1577 | 85.5% | 50% | 1040 |
| Example 8 | 8 | 4 | 100 | 48 | 49 | 15% | 48% | 0.0150 | 8.0 | 4.6 | 1581 | 85.1% | 44% | 1190 |
| Example 9 | 4 | 2 | 100 | 48 | 49 | 15% | 48% | 0.0150 | 8.0 | 4.6 | 1583 | 84.5% | 40% | 1360 |
| Example 10 | 2 | 1 | 100 | 48 | 49 | 15% | 48% | 0.0150 | 8.0 | 4.6 | 1579 | 83.9% | 39% | 1410 |
| Example 11 | 6 | 3 | 300 | 52 | 45 | 15% | 49% | 0.0100 | 8.0 | 3.1 | 1519 | 80.8% | 46% | 1210 |
| Example 12 | 6 | 3 | 200 | 49 | 48 | 15% | 48% | 0.0150 | 8.0 | 4.0 | 1576 | 84.8% | 42% | 1350 |
| Example 13 | 6 | 3 | 150 | 48 | 49 | 15% | 48% | 0.0150 | 8.0 | 4.5 | 1583 | 84.9% | 43% | 1340 |
| Example 14 | 6 | 3 | 50 | 47 | 50 | 15% | 48% | 0.0150 | 8.0 | 4.6 | 1598 | 84.1% | 43% | 1290 |
| Example 15 | 6 | 3 | 10 | 47 | 50 | 15% | 48% | 0.0150 | 8.0 | 4.3 | 1601 | 83.9% | 42% | 1270 |
| Example 16 | 6 | 3 | 0 | 46 | 51 | 15% | 47% | 0.0180 | 8.0 | 6.8 | 1495 | 80.0% | 48% | 1010 |
| Example 17 | 6 | 3 | 100 | 57 | 40 | 15% | 48% | 0.0120 | 8.5 | 4.7 | 1255 | 84.1% | 46% | 1190 |
| Example 18 | 6 | 3 | 100 | 43 | 54 | 15% | 48% | 0.0180 | 8.0 | 4.9 | 1689 | 83.9% | 39% | 1230 |
| Example 19 | 6 | 3 | 100 | 61 | 36 | 15% | 50% | 0.0050 | 8.5 | 2.0 | 1106 | 83.3% | 55% | 980 |
| Example 20 | 6 | 3 | 100 | 38 | 61 | 15% | 46% | 0.0230 | 8.0 | 8.4 | 1933 | 77.5% | 40% | 1070 |
| Example 21 | 3 | 6 | 100 | 48 | 49 | 15% | 48% | 0.0150 | 8.0 | 4.9 | 1594 | 84.3% | 49% | 1233 |
| Comparative Example 1 | / | / | / | 46 | 48 | / | / | / | 9.0 | 1.2 | 1575 | 81.2% | 52% | 614 |
| Comparative Example 2 | 6 | / | 100 | 48 | 49 | / | / | 0.0150 | 8.0 | 4.5 | 1582 | 84.6% | 55% | 1150 |
| Comparative Example 3 | / | / | 100 | 48 | 49 | / | / | 0.0150 | 8.0 | 4.7 | 1564 | 80.1% | 36% | 1310 |

**Table 3**

| No. | γ1 | γ2 | α1 | α2 |
|---|---|---|---|---|
| Example 1 | 15% | 48% | 3.1: 100 | 6.5: 100 |
| Example 2 | 20% | 43% | 10:100 | 1.8: 100 |
| Example 3 | 25% | 38% | 40: 100 | 0: 100 |
| Example 4 | 10% | 53% | 0: 100 | 12:100 |
| Example 5 | 5% | 58% | 0: 100 | 25: 100 |
| Example 6 | 40% | 25% | 120: 100 | 0: 100 |
| Example 21 | 15% | 48% | 100: 0 | 57: 100 |

From the test results in Table 2, it can be seen that by making at least a part of the silicon-based material in the pore structures of the matrix material, and using the silicon-based material comprising a first silicon-based material with a relatively large grain size and a second silicon-based material with a relatively small grain size, the negative electrode active material can have high capacity, high First Coulombic Efficiency and low volume expansion, and the secondary battery can further have high energy density, high First Coulombic Efficiency, long cycle life and long storage life at the same time.

Based on the test results of Example 1 and Example 21, it can also be seen that by using the first silicon-based material with a relatively large grain size mainly located in the inner region of the negative electrode active material, and using the second silicon-based material with a relatively small grain size mainly located in the outer region of the negative electrode active material, not only the improvement effect of the first silicon-based material on the First Coulombic Efficiency can be fully exerted, but also the improvement effect of the second silicon-based material on cycle performance and the reduction effect of the second silicon-based material on volume expansion can be fully exerted. Therefore, it can make the secondary battery better having high energy density, high First Coulombic Efficiency, long cycle life and long storage life at the same time.

Based on the test results in Table 2, it can be seen that when the negative electrode active material further satisfies the ratio γ1 of the total cross-sectional area of the first silicon-based material to the total cross-sectional area of the negative electrode active material being greater than 0 and less than or equal to 25%, optionally from 5% to 20 %, the secondary battery using the negative active material can better have high energy density, high First Coulombic Efficiency, long cycle life and long storage life at the same time.

It can also be seen from the test results of Table 2 and Table 3 that when the negative electrode active material still satisfies that the total cross-sectional area of the first silicon-based material in the outer region is smaller than the total cross-sectional area of the first silicon-based material in the inner region, and optionally the ratio α1 of the total cross-sectional area of the first silicon-based material in the outer region to the total cross-sectional area of the first silicon-based material in the inner region is (0-50): 100, more preferably (0-10): 100, the secondary battery using the negative electrode active material can better have high energy density, high First Coulombic Efficiency, long cycle life and long storage life at the same time.

In Comparative Example 1 using carbon-coated crystalline silicon as the negative electrode active material, crystalline silicon has a huge volume effect, while the carbon layer on the surface has limited protective effect on crystalline silicon; and the carbon layer will crack after repeated charging and discharging; as a result, the SEI film is repeatedly destroyed and rebuilt, which increases the irreversible consumption of active ions; and as the number of charge and discharge increases, the thickness of the SEI film also increases, and the impedance of the secondary battery will also continuously increase. As a result, the secondary battery prepared in Comparative Example 1 shows poor cycle performance.

In the negative electrode active material prepared in Comparative Example 2, the grain sizes of the crystalline silicon-based materials are the same. So, the crystalline silicon-based material has large volume expansion and poor structural stability, which leads to poor cycle performance and volume expansion of the secondary battery. As a result, the secondary battery cannot have high energy density, high First Coulombic Efficiency, long cycle life and long storage life at the same time.

In the negative electrode active material prepared in Comparative Example 3, the silicon-based material only includes amorphous silicon-based materials, without crystalline silicon-based materials; and due to the low First Coulombic Efficiency of amorphous silicon-based materials, the secondary battery has a large actual capacity loss. As a result, the secondary battery cannot have high energy density, high First Coulombic Efficiency, long cycle life and long storage life at the same time, either.

## Claims

1. A negative electrode active material (100), wherein the negative electrode active material (100) comprises a matrix material and a silicon-based material, the matrix material comprises a plurality of pore structures, at least a part of the silicon-based material is located in pore structures of the matrix material, at least a part of the silicon-based material has a crystalline structure, the silicon-based material comprises a first silicon-based material and a second silicon-based material with different grain sizes, and a ratio of grain size of the first silicon-based material to grain size of the second silicon-based material is (1.6-4): 1,
**characterized in that** the grain size of the first silicon-based material is greater than 0 nm and less than or equal to 20 nm, the grain size of the second silicon-based material is greater than 0 nm and less than or equal to 12 nm, and
a region formed by extending from outer surface of particle of the negative electrode active material (100) to inside of the particle by a distance of 0.5 times a length between any point on the outer surface of the particle of the negative electrode active material (100) and a core of particle (O) is recorded as an outer region (101), and a region inside the outer region (101) is recorded as an inner region (102), and in cross-sectional image of the negative electrode active material (100), total cross-sectional area of the first silicon-based material in the outer region (101) is smaller than total cross-sectional area of the first silicon-based material in the inner region (102); and total cross-sectional area of the second silicon-based material in the inner region (102) is smaller than total cross-sectional area of the second silicon-based material in the outer region (101),
wherein the grain size and the cross-sectional areas are measured according to the description.

2. The negative electrode active material (100) according to claim 1, wherein,
the ratio of grain size of the first silicon-based material to grain size of the second silicon-based material is (2-4): 1; and/or,
grain size of the first silicon-based material is from 2 nm to 20 nm; and/or,
grain size of the second silicon-based material is from 1 nm to 12 nm,

3. The negative electrode active material (100) according to claim 1 or 2, wherein a ratio α1 of the total cross-sectional area of the first silicon-based material in the outer region (101) to the total cross-sectional area of the first silicon-based material in the inner region (102) is (0-50): 100, optionally (0-10): 100;
and/or a ratio α2 of the total cross-sectional area of the second silicon-based material in the inner region (102) to the total cross-sectional area of the second silicon-based material in the outer region (101) is (0-30):100, optionally (0-10):100.

4. The negative electrode active material (100) according to claim 3, wherein the cross-sectional image of the negative electrode active material (100) comprises a cross-sectional image passing through the core of particle (O) of the negative electrode active material (100).

5. The negative electrode active material (100) according to claim 3 or 4, wherein,
in the outer region (101) of the cross-sectional image of the negative electrode active material (100), a ratio β1 of the total cross-sectional area of the first silicon-based material to the total cross-sectional area of the second silicon-based material is (0-25):100, optionally (0-5):100, and more optionally the total cross-sectional area of the first silicon-based material is 0; and/or
in inner region (102) of the cross-sectional image of the negative electrode active material (100), a ratio β2 of the total cross-sectional area of the first silicon-based material to the total cross-sectional area of the second silicon-based material is 100:(0-250), optionally 100:(0-100).

6. The negative electrode active material (100) according to any one of claims 3 to 5, wherein
in cross-sectional image of the negative electrode active material (100), a ratio γ1 of the total cross-sectional area of the first silicon-based material to the total cross-sectional area of the negative electrode active material (100) is greater than 0 and less than or equal to 25%, and optionally from 5% to 20%; and/or,
in cross-sectional image of the negative electrode active material (100), a ratio γ2 of the total cross-sectional area of the second silicon-based material to the total cross-sectional area of the negative electrode active material (100) is greater than 35% and less than 100%, and optionally from 40% to 60%.

7. The negative electrode active material (100) according to any one of claims 1 to 6, wherein mass percentage amount of the first silicon-based material in the silicon-based material is greater than 0 and less than or equal to 40 wt%, optionally from 10 wt% to 30 wt%;
and/or
wherein at least a part of the silicon-based material is located in the pore structures of the matrix material, and there is/are internal void(s) between the silicon-based material and the matrix material.

8. The negative electrode active material (100) according to any one of claims 1 to 7, wherein
the first silicon-based material comprises one or more of elemental silicon, silicon oxide, silicon-carbon material, silicon-nitrogen composite, and silicon alloy, optionally comprises elemental silicon; and/or,
the second silicon-based material comprises one or more of elemental silicon, silicon oxide, silicon-carbon material, silicon-nitrogen composite, and silicon alloy, optionally comprises elemental silicon; and/or,
the materials of the first silicon-based material and the second silicon-based material are the same, and optionally, both the first silicon-based material and the second silicon-based material are elemental silicon; and/or,
the silicon-based material comprises a vapor-deposited silicon-based material, optionally comprises vapor-deposited elemental silicon.

9. The negative electrode active material (100) according to any one of claims 1 to 8, wherein,
the first silicon-based material comprises elemental silicon, and the grain size of the first silicon-based material is greater than 0 nm and less than or equal to 8 nm, optionally from 2 nm to 8 nm; and/or,
the first silicon-based material comprises elemental silicon, and the grain size of the first silicon-based material is greater than 0 nm and less than or equal to 5 nm, optionally from 1 nm to 5 nm.

10. The negative electrode active material (100) according to any one of claims 1 to 9, wherein the matrix material satisfies at least one of the following (1) to (3):
(1) the matrix material has a porosity of from 30% to 60%, optionally from 40% to 50%;
(2) the matrix material comprises one or more of carbon material, graphite material and transition metal oxide material; and
(3) the matrix material comprises a carbon material, and the carbon material comprises one or more of activated carbon, biomass carbon, pyrolytic carbon and resin carbon.

11. The negative electrode active material (100) according to any one of claims 1 to 10, wherein the negative electrode active material (100) further comprises a coating layer which is located on at least part of surface of the matrix,
optionally, the coating layer satisfies at least one of the following conditions (1) to (3):
(1) the coating layer comprises one or more of carbon materials, conductive polymers, metal oxides and metal sulfides;
(2) the coating layer comprises carbon material, and optionally, the carbon material comprises one or more of hard carbon, soft carbon, graphene, carbon fiber, and carbon nanotube; and
(3) the coating layer has a thickness of from 0 nm to 200 nm, optionally from 10 nm to 150 nm.

12. The negative electrode active material (100) according to any one of claims 1 to 11, wherein the negative electrode active material (100) comprises carbon element and silicon element,
optionally, mass percentage amount of carbon element in the negative electrode active material (100) is from 40 wt% to 60 wt%, more optionally from 45 wt% to 50 wt%;
optionally, mass percentage amount of silicon element in the negative electrode active material (100) is from 38 wt% to 58 wt%, more optionally from 40 wt% 55 wt%.

13. The negative electrode active material (100) according to claim 12, wherein the negative electrode active material (100) further comprises other element(s) comprising one or more of oxygen element, metal element and nitrogen element,
optionally, a sum of mass percentage amount(s) of other element(s) in the negative electrode active material (100) is from 0 wt% to 20 wt%, more optionally from 0 wt% 10 wt%.

14. The negative electrode active material (100) according to claims 1 to 13, wherein,
the negative electrode active material (100) has a pore volume of from 0.001 cm³/g to 0.02 cm³/g, optionally from 0.01 cm³/g to 0.02 cm³/g; and/or,
the negative electrode active material (100) has an average particle size Dv50 of from 4 µm to 12 µm; and/or,
the negative electrode active material (100) has a BET specific surface area of from 1 m²/g to 15 m²/g.

15. A method for preparing a negative electrode active material (100), comprising the steps of: providing a matrix material comprising a plurality of pore structures; dispersing a silicon-based material into the pore structures of the matrix material to obtain a negative electrode active material (100), wherein the negative electrode active material (100) comprises a matrix material and a silicon-based material, the matrix material comprises a plurality of pore structures, and at least a part of the silicon-based material is located in pore structures of the matrix material, at least a part of the silicon-based material has a crystalline structure, the silicon-based material comprises a first silicon-based material and a second silicon-based material with different grain sizes, and a ratio of grain size of the first silicon-based material to grain size of the second silicon-based material is (1.6-4): 1, wherein grain size of the first silicon-based material is greater than 0 nm and less than or equal to 20 nm, grain size of the second silicon-based material is greater than 0 nm and less than or equal to 12 nm
wherein the step of dispersing the silicon-based material into the pore structures of the matrix material comprises the following steps of: placing the matrix material comprising a plurality of pore structures as a substrate in a reaction furnace, and feeding a first mixture gas comprising silicon source gas and depositing at a first temperature T₁ for a first time t₁, stopping feeding of the first mixture gas at the end of depositing; when the temperature in the furnace drops to the second temperature T₂, feeding a second mixture gas comprising silicon source gas, and depositing at a second temperature T₂ for a second time t₂, and after the end of depositing, a negative electrode active material (100) is obtained,
wherein a region formed by extending from outer surface of particle of the negative electrode active material (100) to inside of the particle by a distance of 0.5 times a length between any point on the outer surface of the particle of the negative electrode active material (100) and a core of particle (O) is recorded as an outer region (101), and a region inside the outer region (101) is recorded as an inner region (102), and in cross-sectional image of the negative electrode active material (100), total cross-sectional area of the first silicon-based material in the outer region (101) is smaller than total cross-sectional area of the first silicon-based material in the inner region (102); and total cross-sectional area of the second silicon-based material in the inner region (102) is smaller than total cross-sectional area of the second silicon-based material in the outer region (101),
wherein:
a volume percentage V₁ of the silicon source gas in the first mixture gas is greater than a volume percentage V₂ of the silicon source gas in the second mixture gas; and/or,${T}_{1} > {T}_{2} ;$ and/or,${t}_{1} < {t}_{2} ,$
wherein the grain size and the cross-sectional areas are measured according to the description.

16. The method of claim 15, wherein, the matrix material satisfies at least one of the following (1) to (4):
(1) the matrix material has a porosity of from 30% to 60%, optionally from 40% to 50%;
(2) the matrix material comprises one or more of carbon material, graphite material and transition metal oxide material; and
(3) the matrix material comprises a carbon material, and the carbon material comprises one or more of activated carbon, biomass carbon, pyrolytic carbon and resin;
(4) the matrix material has an average particle size Dv50 of from 4 µm to 12 µm.

17. The method according to claim 15 or 16, wherein the method further comprises the steps of: before feeding the first mixture gas comprising silicon source gas, placing the matrix material comprising a plurality of pore structures as a substrate in the reaction furnace, and purging with a protective gas for purge treatment and pre-heating treatment, optionally, the temperature for pre-heating is from 200°C to 300°C;
and/or
wherein,
the first mixture gas comprises a silicon source gas and a protective gas, and optionally, the volume percentage V₁ of the silicon source gas in the first mixture gas is from 10% to 50%; and/or
the first mixture gas has a total gas flow rate of from 0.5 L/min to 20 L/min; and/or
the first temperature T₁ is from 500°C to 700°C; and/or,
the first time t₁ is from 0.5 h to 8 h, optionally from 0.5 h to 4 h;
and/or
wherein,
the second mixture gas comprises a silicon source gas and a protective gas, and optionally, the volume percentage V₂ of the silicon source gas in the second mixture gas is from 10% to 25%; and/or
the second mixture gas has a total gas flow rate of from 0.5 L/min to 20 L/min; and/or
the second temperature T₂ is from 500°C to 600°C; and/or,
the second time t₂ is from 4 h to 20 h, optionally from 4 h to 16 h; and/or,
the total gas flow rate of the second mixture gas be the same as that of the first mixture gas.

18. The method according to any one of claims 15-17, further comprising the step of: forming a coating layer on at least part of surface of the obtained negative electrode active material (100), and the coating layer comprises one or more of carbon materials, conductive polymers, metal oxides and metal sulfides; and
wherein preferably, the step of forming a coating layer comprising the following steps of: placing the obtained negative electrode active material (100) in a reaction furnace, feeding the third mixture gas containing carbon source gas, and depositing at a third temperature T₃ for a third time t₃, to obtain a carbon-coated negative electrode active material (100); and,
wherein more preferably,
the third mixture gas comprises a carbon source gas and a protective gas, and optionally, the volume percentage V₃ of the carbon source gas in the third mixture gas is from 10% to 50%; and/or,
the third mixture gas has a total gas flow rate of from 0.5 L/min to 20 L/min; and/or
the third temperature T₃ is from 600°C to 800°C; and/or,
the third time t₃ is from 0.5 h to 4 h.

19. A secondary battery, comprising a negative electrode plate, wherein the negative electrode plate comprises a negative electrode active material (100) according to any one of claims 1 to 14.

## Patentansprüche

1. Negativelektroden-Aktivmaterial (100), wobei das Negativelektroden-Aktivmaterial (100) ein Matrixmaterial und ein Material auf Siliciumbasis umfasst, wobei das Matrixmaterial eine Vielzahl von Porenstrukturen umfasst, mindestens ein Teil des Materials auf Siliciumbasis sich in Porenstrukturen des Matrixmaterials befindet, mindestens ein Teil des Materials auf Siliciumbasis eine kristalline Struktur hat, das Material auf Siliciumbasis ein erstes Material auf Siliciumbasis und ein zweites Material auf Siliciumbasis mit unterschiedlichen Korngrößen umfasst, und ein Verhältnis der Korngröße des ersten Materials auf Siliciumbasis zu der Korngröße des zweiten Materials auf Siliciumbasis (1,6-4):1 beträgt,
**dadurch gekennzeichnet, dass**
die Korngröße des ersten Materials auf Siliciumbasis größer als 0 nm und kleiner als oder gleich 20 nm ist, die Korngröße des zweiten Materials auf Siliciumbasis größer als 0 nm und kleiner als oder gleich 12 nm ist,
und eine Region, die gebildet wird, indem sie sich von der Außenoberfläche des Partikels des Negativelektroden-Aktivmaterials (100) um eine Distanz des 0,5-fachen einer Länge zwischen einem beliebigen Punkt auf der Außenoberfläche des Partikels des Negativelektroden-Aktivmaterials (100) und eines Kerns des Partikels (O) in das Innere des Partikels erstreckt, als Außenregion (101) aufgezeichnet wird, und eine Region innerhalb der Außenregion (101) als Innenregion (102) aufgezeichnet wird, und im Querschnittbild des Negativelektroden-Aktivmaterials (100) die gesamte Querschnittfläche des ersten Materials auf Siliciumbasis in der Außenregion (101) kleiner als die gesamte Querschnittfläche des ersten Materials auf Siliciumbasis in der Innenregion (102) ist; und die gesamte Querschnittfläche des zweiten Materials auf Siliciumbasis in der Innenregion (102) kleiner als die gesamte Querschnittfläche des zweiten Materials auf Siliciumbasis in der Außenregion (101) ist,
wobei die Korngröße und die Querschnittflächen gemäß den technischen Angaben gemessen werden.

2. Negativelektroden-Aktivmaterial (100) nach Anspruch 1, wobei
das Verhältnis der Korngröße des ersten Materials auf Siliciumbasis zu der Korngröße des zweiten Materials auf Siliciumbasis (2-4):1 beträgt; und/oder
die Korngröße des ersten Materials auf Siliciumbasis 2 nm bis 20 nm beträgt; und/oder
die Korngröße des zweiten Materials auf Siliciumbasis 1 nm bis 12 nm beträgt.

3. Negativelektroden-Aktivmaterial (100) nach Anspruch 1 oder 2, wobei ein Verhältnis α1 der gesamten Querschnittfläche des ersten Materials auf Siliciumbasis in der Außenregion (101) zu der gesamten Querschnittfläche des ersten Materials auf Siliciumbasis in der Innenregion (102) (0-50):100, gegebenenfalls (0-10):100 beträgt;
und/oder ein Verhältnis α2 der gesamten Querschnittfläche des zweiten Materials auf Siliciumbasis in der Innenregion (102) zu der gesamten Querschnittfläche des zweiten Materials auf Siliciumbasis in der Außenregion (101) (0-30):100, gegebenenfalls (0-10):100 beträgt.

4. Negativelektroden-Aktivmaterial (100) nach Anspruch 3, wobei das Querschnittbild des Negativelektroden-Aktivmaterials (100) ein Querschnittbild umfasst, welches durch den Kern des Partikels (O) des Negativelektroden-Aktivmaterials (100) verläuft.

5. Negativelektroden-Aktivmaterial (100) nach Anspruch 3 oder 4, wobei
in der Außenregion (101) des Querschnittbildes des Negativelektroden-Aktivmaterials (100) ein Verhältnis β1 der gesamten Querschnittfläche des ersten Materials auf Siliciumbasis zu der gesamten Querschnittfläche des zweiten Materials auf Siliciumbasis (0-25):100, gegebenenfalls (0-5):100 beträgt, und als besondere Option die gesamte Querschnittfläche des ersten Materials auf Siliciumbasis 0 beträgt; und/oder
in der Innenregion (102) des Querschnittbildes des Negativelektroden-Aktivmaterials (100) ein Verhältnis β2 der gesamten Querschnittfläche des ersten Materials auf Siliciumbasis zu der gesamten Querschnittfläche des zweiten Materials auf Siliciumbasis 100:(0-250), gegebenenfalls 100:(0-100) beträgt.

6. Negativelektroden-Aktivmaterial (100) nach einem der Ansprüche 3 bis 5, wobei im Querschnittbild des Negativelektroden-Aktivmaterials (100) das Verhältnis γ1 der gesamten Querschnittfläche des ersten Materials auf Siliciumbasis zu der gesamten Querschnittfläche des Negativelektroden-Aktivmaterials (100) größer als 0 und kleiner als oder gleich 25 % ist und gegebenenfalls 5 % bis 20 % beträgt; und/oder
im Querschnittbild des Negativelektroden-Aktivmaterials (100) das Verhältnis γ2 der gesamten Querschnittfläche des zweiten Materials auf Siliciumbasis zu der gesamten Querschnittfläche des Negativelektroden-Aktivmaterials (100) größer als 35 % und kleiner als 100 % ist und gegebenenfalls 40 % bis 60 % ist.

7. Negativelektroden-Aktivmaterial (100) nach einem der Ansprüche 1 bis 6, wobei die Massenprozentsatzmenge des ersten Materials auf Siliciumbasis in dem Material auf Siliciumbasis größer als 0 und kleiner als oder gleich 40 Gew.%, gegebenenfalls 10 Gew.% bis 30 Gew.% ist; und/oder
wobei mindestens ein Teil des Materials auf Siliciumbasis sich in den Porenstrukturen des Matrixmaterials befindet, und es internen Leerraum/interne Leerräume zwischen dem Material auf Siliciumbasis und dem Matrixmaterial gibt.

8. Negativelektroden-Aktivmaterial (100) nach einem der Ansprüche 1 bis 7, wobei
das erste Material auf Siliciumbasis ein oder mehrere von elementarem Silicium, Siliciumoxid, Silicium-Kohlenstoff-Material, Silicium-Stickstoff-Verbund und Siliciumlegierung umfasst, gegebenenfalls elementares Silicium umfasst; und/oder
das zweite Material auf Siliciumbasis ein oder mehrere von elementarem Silicium, Siliciumoxid, Silicium-Kohlenstoff-Material, Silicium-Stickstoff-Verbund und Siliciumlegierung umfasst, gegebenenfalls elementares Silicium umfasst; und/oder
die Materialien des ersten Materials auf Siliciumbasis und des zweiten Materials auf Siliciumbasis die gleichen sind, und gegebenenfalls sowohl das erste Material auf Siliciumbasis als auch das zweite Material auf Siliciumbasis elementares Silicium sind; und/oder
das Material auf Siliciumbasis ein aus der Gasphase abgeschiedenes Material auf Siliciumbasis umfasst, gegebenenfalls aus der Gasphase abgeschiedenes elementares Silicium umfasst.

9. Negativelektroden-Aktivmaterial (100) nach einem der Ansprüche 1 bis 8, wobei
das erste Material auf Siliciumbasis elementares Silicium umfasst, und die Korngröße des ersten Materials auf Siliciumbasis größer als 0 nm und kleiner als oder gleich 8 nm ist, gegebenenfalls 2 nm bis 8 nm; und/oder
das erste Material auf Siliciumbasis elementares Silicium umfasst, und die Korngröße des ersten Materials auf Siliciumbasis größer als 0 nm und kleiner als oder gleich 5 nm ist, gegebenenfalls 1 nm bis 5 nm.

10. Negativelektroden-Aktivmaterial (100) nach einem der Ansprüche 1 bis 9, wobei das Matrixmaterial mindestens eines der folgenden (1) bis (3) erfüllt:
(1) das Matrixmaterial hat eine Porosität von 30 % bis 60 %, gegebenenfalls 40 % bis 50 %;
(2) das Matrixmaterial umfasst ein oder mehrere von Kohlenstoffmaterial, Graphitmaterial und Übergangsmetalloxidmaterial; und
(3) das Matrixmaterial umfasst ein Kohlenstoffmaterial, und das Kohlenstoffmaterial umfasst ein oder mehrere von Aktivkohle, Biomassenkohlenstoff, Pyrolysekohlenstoff und Harzkohlenstoff.

11. Negativelektroden-Aktivmaterial (100) nach einem der Ansprüche 1 bis 10, wobei das Negativelektroden-Aktivmaterial (100) des Weiteren eine Beschichtungsschicht umfasst, die sich auf mindestens einem Teil der Oberfläche der Matrix befindet,
wobei die Beschichtungsschicht gegebenenfalls mindestens eine der folgenden Bedingungen (1) bis (3) erfüllt:
(1) die Beschichtungsschicht umfasst ein oder mehrere von Kohlenstoffmaterialien, leitfähigen Polymeren, Metalloxiden und Metallsulfiden;
(2) die Beschichtungsschicht umfasst Kohlenstoffmaterial, und das Kohlenstoffmaterial umfasst gegebenenfalls ein oder mehrere von Hartkohlenstoff, Weichkohlenstoff, Graphen, Kohlefaser und Kohlenstoffnanoröhrchen; und
(3) die Beschichtungsschicht hat eine Dicke von 0 nm bis 200 nm, gegebenenfalls 10 nm bis 150 nm.

12. Negativelektroden-Aktivmaterial (100) nach einem der Ansprüche 1 bis 11, wobei das Negativelektroden-Aktivmaterial (100) Kohlenstoffelement und Siliciumelement umfasst,
wobei die Massenprozentsatzmenge des Kohlenstoffelements in dem Negativelektroden-Aktivmaterial (100) 40 Gew.% bis 60 Gew.% und als besondere Option 45 Gew.% bis 50 Gew.% beträgt;
gegebenenfalls die Massenprozentsatzmenge an Siliciumelement in dem Negativelektroden-Aktivmaterial (100) 38 Gew.% bis 58 Gew.% und als besondere Option 40 Gew.% bis 55 Gew.% beträgt.

13. Negativelektroden-Aktivmaterial (100) nach Anspruch 12, wobei das Negativelektroden-Aktivmaterial (100) des Weiteren anderes Element/andere Elemente umfasst, das/die ein oder mehrere von Sauerstoffelement, Metallelement und Stickstoffelement umfasst/umfassen,
gegebenenfalls eine Summe der Massenprozentsatzmenge(n) an anderem Element/anderen Elementen in dem Negativelektroden-Aktivmaterial (100) 0 Gew.% bis 20 Gew.% und als besondere Option 0 Gew.% bis 10 Gew.% beträgt.

14. Negativelektroden-Aktivmaterial (100) nach den Ansprüchen 1 bis 13, wobei
das Negativelektroden-Aktivmaterial (100) ein Porenvolumen von 0,001 cm³/g bis 0,02 cm³/g, gegebenenfalls 0,01 cm³/g bis 0,02 cm³/g hat; und/oder
das Negativelektroden-Aktivmaterial (100) eine durchschnittliche Partikelgröße Dv50 von 4 µm bis 12 µm hat; und/oder
das Negativelektroden-Aktivmaterial (100) eine spezifische BET-Oberfläche von 1 m²/g bis 15 m²/g hat.

15. Verfahren zur Herstellung eines Negativelektroden-Aktivmaterials (100), umfassend die Schritte: Bereitstellen eines Matrixmaterials, das eine Vielzahl von Porenstrukturen umfasst; Dispergieren eines Materials auf Siliciumbasis in die Porenstrukturen des Matrixmaterials hinein, um ein Negativelektroden-Aktivmaterial (100) zu erhalten, wobei das Negativelektroden-Aktivmaterial (100) ein Matrixmaterial und ein Material auf Siliciumbasis umfasst, das Matrixmaterial eine Vielzahl von Porenstrukturen umfasst, und mindestens ein Teil des Materials auf Siliciumbasis sich in Porenstrukturen des Matrixmaterials befindet, mindestens ein Teil des Materials auf Siliciumbasis eine kristalline Struktur hat, das Material auf Siliciumbasis ein erstes Material auf Siliciumbasis und ein zweites Material auf Siliciumbasis mit unterschiedlichen Korngrößen umfasst, und ein Verhältnis der Korngröße des ersten Materials auf Siliciumbasis zu Korngröße des zweiten Materials auf Siliciumbasis (1,6-4):1 beträgt, wobei die Korngröße des ersten Materials auf Siliciumbasis größer als 0 nm und kleiner als oder gleich 20 nm ist, die Korngröße des zweiten Materials auf Siliciumbasis größer als 0 nm und kleiner als oder gleich 12 nm ist,
wobei der Schritt des Dispergierens des Materials auf Siliciumbasis in die Porenstrukturen des Matrixmaterials hinein die folgenden Schritte umfasst: Platzieren des Matrixmaterials, das eine Vielzahl von Porenstrukturen umfasst, als ein Substrat in einem Reaktionsofen, und Einspeisen eines ersten Mischungsgases, das Siliciumquellgas umfasst, und Abscheiden bei einer ersten Temperatur T₁ für eine erste Zeit t₁, Stoppen des Einspeisens des ersten Mischungsgases am Ende des Abscheidens; wenn die Temperatur in dem Ofen auf die zweite Temperatur T₂ fällt, Einspeisen eines zweiten Mischungsgases, das Siliciumquellgas umfasst, und Abscheiden bei einer zweiten Temperatur T₂ für eine zweite Zeit t₂, und wobei nach dem Ende des Abscheidens ein Negativelektroden-Aktivmaterial (100) erhalten wird,
wobei eine Region, die gebildet wird, indem sie sich von der Außenoberfläche des Partikels des Negativelektroden-Aktivmaterials (100) um eine Distanz des 0,5-fachen einer Länge zwischen einem beliebigen Punkt auf der Außenoberfläche des Partikels des Negativelektroden-Aktivmaterials (100) und eines Kerns des Partikels (O) in das Innere des Partikels erstreckt, als Außenregion (101) aufgezeichnet wird, und eine Region innerhalb der Außenregion (101) als Innenregion (102) aufgezeichnet wird, und im Querschnittbild des Negativelektroden-Aktivmaterials (100) die gesamte Querschnittfläche des ersten Materials auf Siliciumbasis in der Außenregion (101) kleiner als die gesamte Querschnittfläche des ersten Materials auf Siliciumbasis in der Innenregion (102) ist; und die gesamte Querschnittfläche des zweiten Materials auf Siliciumbasis in der Innenregion (102) kleiner als die gesamte Querschnittfläche des zweiten Materials auf Siliciumbasis in der Außenregion (101) ist,
wobei:
ein Volumenprozentsatz V₁ des Siliciumquellgases in dem ersten Mischungsgas größer als ein Volumenprozentsatz V₂ des Siliciumquellgases in dem zweiten Mischungsgas ist; und/oder ${T}_{1} > {T}_{2} ;$ und/oder${t}_{1} < {t}_{2} ,$
wobei die Korngröße und die Querschnittflächen gemäß den technischen Angaben gemessen werden.

16. Verfahren nach Anspruch 15, wobei das Matrixmaterial mindestens eines der folgenden (1) bis (4) erfüllt:
(1) das Matrixmaterial hat eine Porosität von 30 % bis 60 %, gegebenenfalls 40 % bis 50 %;
(2) das Matrixmaterial umfasst ein oder mehrere von Kohlenstoffmaterial, Graphitmaterial und Übergangsmetalloxidmaterial; und
(3) das Matrixmaterial umfasst ein Kohlenstoffmaterial, und das Kohlenstoffmaterial umfasst ein oder mehrere von Aktivkohle, Biomassenkohlenstoff, Pyrolysekohlenstoff und Harz;
(4) das Matrixmaterial hat eine durchschnittliche Partikelgröße Dv50 von 4 µm bis 12 µm.

17. Verfahren nach Anspruch 15 oder 16, wobei das Verfahren des Weiteren die Schritte umfasst: vor dem Einspeisen des ersten Mischungsgases, das Siliciumquellgas umfasst, Platzieren des Matrixmaterials, das eine Vielzahl von Porenstrukturen umfasst, als ein Substrat in dem Reaktionsofen, und Säubern mit einem Schutzgas zur Säuberungsbehandlung und Vorheizbehandlung, wobei die Temperatur für das Vorheizen gegebenenfalls 200 °C bis 300 °C beträgt;
und/oder
wobei das erste Mischungsgas ein Siliciumquellgas und ein Schutzgas umfasst, und gegebenenfalls der Volumenprozentsatz V₁ des Siliciumquellgases in dem ersten Mischungsgas 10 % bis 50 % beträgt; und/oder
das erste Mischungsgas eine gesamte Gasflussrate von 0,5 L/min bis 20 L/min hat; und/oder
die erste Temperatur T₁ 500 °C bis 700 °C beträgt; und/oder
die erste Zeit t₁ 0,5 h bis 8 h, gegebenenfalls 0,5 h bis 4 h beträgt; und/oder
wobei das zweite Mischungsgas ein Siliciumquellgas und ein Schutzgas umfasst, und gegebenenfalls der Volumenprozentsatz V₂ des Siliciumquellgases in dem zweiten Mischungsgas 10 % bis 25 % beträgt; und/oder
das zweite Mischungsgas eine gesamte Gasflussrate von 0,5 L/min bis 20 L/min hat; und/oder
die zweite Temperatur T₂ 500 °C bis 600 °C beträgt; und/oder
die zweite Zeit t₂ 4 h bis 20 h, gegebenenfalls 4 h bis 16 h beträgt; und/oder,
die gesamte Gasflussrate des zweiten Mischungsgases dieselbe wie diejenige des ersten Mischungsgases ist.

18. Verfahren nach einem der Ansprüche 15-17, ferner umfassend den Schritt: Bilden einer Beschichtungsschicht auf mindestens einem Teil der Oberfläche des erhaltenen Negativelektroden-Aktivmaterials (100), und wobei die Beschichtungsschicht ein oder mehrere von Kohlenstoffmaterialien, leitfähigen Polymeren, Metalloxiden und Metallsulfiden umfasst; und
wobei der Schritt des Bildens einer Beschichtungsschicht vorzugsweise die folgenden Schritte umfasst: Platzieren des erhaltenen Negativelektroden-Aktivmaterials (100) in einem Reaktionsofen, Einspeisen des dritten Mischungsgases, das Kohlenstoffquellgas enthält, und Abscheiden bei einer dritten Temperatur T₃ für eine dritte Zeit t₃, um ein kohlenstoffbeschichtetes Negativelektroden-Aktivmaterial (100) zu erhalten; und
wobei bevorzugter das dritte Mischungsgas ein Kohlenstoffquellgas und ein Schutzgas umfasst, und gegebenenfalls der Volumenprozentsatz V₃ des Kohlenstoffquellgases in dem dritten Mischungsgas 10 % bis 50 % beträgt; und/oder
das dritte Mischungsgas eine gesamte Gasflussrate von 0,5 L/min bis 20 L/min hat; und/oder
die dritte Temperatur T₃ 600 °C bis 800 °C beträgt; und/oder
die dritte Zeit t₃ 0,5 h bis 4 h beträgt.

19. Sekundärbatterie, umfassend eine Negativelektrodenplatte, wobei die Negativelektrodenplatte ein Negativelektroden-Aktivmaterial (100) nach einem der Ansprüche 1 bis 14 umfasst.

## Revendications

1. Matériau actif d'électrode négative (100), le matériau actif d'électrode négative (100) comprenant un matériau de matrice et un matériau à base de silicium, le matériau de matrice comprenant une pluralité de structures de pores, au moins une partie du matériau à base de silicium étant située dans des structures de pores du matériau de matrice, au moins une partie du matériau à base de silicium ayant une structure cristalline, le matériau à base de silicium comprenant un premier matériau à base de silicium et un deuxième matériau à base de silicium ayant des tailles de grains différentes, et un rapport de taille de grains du premier matériau à base de silicium sur taille de grains du deuxième matériau à base de silicium étant (1,6 à 4): 1,
**caractérisé en ce que** la taille de grains du premier matériau à base de silicium est supérieure à 0 nm et inférieure ou égale à 20 nm, la taille de grains du deuxième matériau à base de silicium est supérieure à 0 nm et inférieure ou égale à 12 nm,
et une zone formée par extension depuis une surface externe de particule du matériau actif d'électrode négative (100) vers l'intérieur de la particule d'une distance de 0,5 fois une longueur entre un quelconque point de la surface externe de la particule du matériau actif d'électrode négative (100) et un noyau de particule (O) est enregistrée comme zone externe (101), et une zone à l'intérieur de la zone externe (101) est enregistrée comme une zone interne (102), et dans une image de section transversale du matériau actif d'électrode négative (100), une aire de section transversale totale du premier matériau à base de silicium dans la zone externe (101) est plus petite qu'une aire de section transversale totale du premier matériau à base de silicium dans la zone interne (102) ; et une aire de section transversale totale du deuxième matériau à base de silicium dans la zone interne (102) est plus petite qu'une aire de section transversale totale du deuxième matériau à base de silicium dans la zone externe (101),
la taille de grains et les aires de section transversale étant mesurées selon la description.

2. Matériau actif d'électrode négative (100) selon la revendication 1,
le rapport de taille de grains du premier matériau à base de silicium sur taille de grains du deuxième matériau à base de silicium étant (2 à 4): 1; et/ou,
la taille de grains du premier matériau à base de silicium étant supérieure de 2 nm à 20 nm; et/ou
la taille de grains du deuxième matériau à base de silicium étant de 1 nm à 12 nm.

3. Matériau actif d'électrode négative (100) selon la revendication 1 ou 2, un rapport α1 de l'aire de section transversale totale du premier matériau à base de silicium dans la zone externe (101) sur l'aire de section transversale totale du premier matériau à base de silicium dans la zone interne (102) étant (0 à 50): 100, éventuellement (0 à 10): 100;
et/ou un rapport α2 de l'aire de section transversale totale du deuxième matériau à base de silicium dans la zone interne (102) sur l'aire de section transversale totale du deuxième matériau à base de silicium dans la zone externe (101) étant (0 à 30): 100, éventuellement (0 à 10): 100.

4. Matériau actif d'électrode négative (100) selon la revendication 3, l'image de section transversale du matériau actif d'électrode négative (100) comprenant une image de section transversale passant à travers le noyau de particule (O) du matériau actif d'électrode négative (100).

5. Matériau actif d'électrode négative (100) selon la revendication 3 ou 4,
dans la zone externe (101) de l'image de section transversale du matériau actif d'électrode négative (100), un rapport β1 de l'aire de section transversale totale du premier matériau à base de silicium sur l'aire de section transversale totale du deuxième matériau à base de silicium étant (0 à 25): 100, éventuellement (0 à 5): 100 et plus éventuellement l'aire de section transversale totale du premier matériau à base de silicium étant 0; et/ou
dans une zone interne (102) de l'image de section transversale du matériau actif d'électrode négative (100), un rapport β2 de l'aire de section transversale totale du premier matériau à base de silicium sur l'aire de section transversale totale du deuxième matériau à base de silicium étant 100: (0 à 250), éventuellement 100: (0 à 100).

6. Matériau actif d'électrode négative (100) selon l'une quelconque des revendications 3 à 5, dans une image de section transversale du matériau actif d'électrode négative (100), un rapport γ1 de l'aire de section transversale totale du premier matériau à base de silicium sur l'aire de section transversale totale du matériau actif d'électrode négative (100) étant supérieur à 0 et inférieur ou égal à 25 %, et éventuellement de 5 % à 20 %; et/ou,
dans une image de section transversale du matériau actif d'électrode négative (100), un rapport γ2 de l'aire de section transversale totale du deuxième matériau à base de silicium sur l'aire de section transversale totale du matériau actif d'électrode négative (100) étant supérieur à 35 % et inférieur à 100 %, et éventuellement de 40 % à 60 %.

7. Matériau actif d'électrode négative (100) selon l'une quelconque des revendications 1 à 6, une quantité en pourcentage en masse du premier matériau à base de silicium dans le matériau à base de silicium étant supérieure à 0 et inférieure ou égale à 40 % en poids, éventuellement de 10 % en poids à 30 % en poids;
et/ou,
au moins une partie du matériau à base de silicium étant située dans les structures de pores du matériau de matrice, et un ou plusieurs vides internes se trouvant entre le matériau à base de silicium et le matériau de matrice.

8. Matériau actif d'électrode négative (100) selon l'une quelconque des revendications 1 à 7, le premier matériau à base de silicium comprenant l'un ou plusieurs parmi le silicium élémentaire, l'oxyde de silicium, un matériau à base de silicium, un composite silicium-azote, et un alliage de silicium, éventuellement comprenant du silicium élémentaire ; et/ou, le deuxième matériau à base de silicium comprenant l'un ou plusieurs parmi le silicium élémentaire, l'oxyde de silicium, un matériau à base de silicium, un composite silicium-azote, et un alliage de silicium, éventuellement comprenant du silicium élémentaire ; et/ou, les matériaux du premier matériau à base de silicium et du deuxième matériau à base de silicium étant les mêmes, et éventuellement, à la fois le premier matériau à base de silicium et le deuxième matériau à base de silicium étant du silicium élémentaire; et/ou,
le matériau à base de silicium comprenant un matériau à base de silicium déposé en phase vapeur, éventuellement comprenant du silicium élémentaire déposé en phase vapeur.

9. Matériau actif d'électrode négative (100) selon l'une quelconque des revendications 1 à 8, le premier matériau à base de silicium comprenant du silicium élémentaire, et la taille de grains du premier matériau à base de silicium étant supérieure à 0 nm et inférieure ou égale à 8 nm, éventuellement de 2 nm à 8 nm; et/ou,
le premier matériau à base de silicium comprenant du silicium élémentaire, et la taille de grains du premier matériau à base de silicium étant supérieure à 0 nm et inférieure ou égale à 5 nm, éventuellement de 1 nm à 5 nm.

10. Matériau actif d'électrode négative (100) selon l'une quelconque des revendications 1 à 9, le matériau de matrice satisfaisant au moins l'un parmi les énoncés suivants (1) à (3):
(1) le matériau de matrice possède une porosité allant de 30 % à 60 %, éventuellement de 40 % à 50 %;
(2) le matériau de matrice comprend l'un ou plusieurs parmi un matériau de carbone, un matériau de graphite et un matériau d'oxyde de métal de transition; et
(3) le matériau de matrice comprend un matériau de carbone, et le matériau de carbone comprend l'un ou plusieurs parmi un carbone activé, un carbone de biomasse, un carbone pyrolytique et un carbone de résine.

11. Matériau actif d'électrode négative (100) selon l'une quelconque des revendications 1 à 10, le matériau actif d'électrode négative (100) comprenant en outre une couche de revêtement qui est située sur au moins une partie de surface de la matrice, éventuellement, la couche de revêtement satisfaisant au moins l'une des conditions suivantes (1) à (3):
(1) la couche de revêtement comprend l'un ou plusieurs parmi des matériaux de carbone, des polymères conducteurs, des oxydes métalliques et des sulfures métalliques;
(2) la couche de revêtement comprend un matériau de carbone, et éventuellement, le matériau de carbone comprend l'un ou plusieurs parmi un carbone dur, un carbone tendre, du graphène, une fibre de carbone et un nanotube de carbone; et
(3) la couche de revêtement possède une épaisseur allant de 0 nm à 200 nm, éventuellement de 10 nm à 150 nm.

12. Matériau actif d'électrode négative (100) selon l'une quelconque des revendications 1 à 11, le matériau actif d'électrode négative (100) comprenant un élément carbone et un élément silicium,
éventuellement, une quantité en pourcentage en masse d'élément carbone dans le matériau actif d'électrode négative (100) étant de 40 % en poids à 60 % en poids, plus éventuellement de 45 % en poids à 50 % en poids ;
éventuellement, une quantité en pourcentage en masse d'élément silicium dans le matériau actif d'électrode négative (100) étant de 38 % en poids à 58 % en poids, plus éventuellement de 40 % en poids à 55 % en poids

13. Matériau actif d'électrode négative (100) selon la revendication 12, le matériau actif d'électrode négative (100) comprenant en outre un ou plusieurs autres éléments comprenant l'un ou plusieurs parmi un élément oxygène, un élément métallique et un élément azote,
éventuellement, une somme d'une ou plusieurs quantités en pourcentage en masse d'un ou plusieurs autres éléments dans le matériau actif d'électrode négative (100) étant de 0 % en poids à 20 % en poids, plus éventuellement de 0 % en poids à 10 % en poids.

14. Matériau actif d'électrode négative (100) selon l'une quelconque des revendications 1 à 13,
le matériau actif d'électrode négative (100) ayant un volume de pores allant de 0,001 cm³/g à 0,02 cm³/g, éventuellement de 0,01 cm³/g à 0,02 cm³/g; et/ou,
le matériau actif d'électrode négative (100) ayant une taille moyenne de particule Dv50 de 4 µm à 12 µm; et/ou,
le matériau actif d'électrode négative (100) ayant une aire de surface spécifique BET allant de 1 m²/g à 15 m²/g.

15. Procédé pour la préparation d'un matériau actif d'électrode négative (100), comprenant les étapes de: fourniture d'un matériau de matrice comprenant une pluralité de structures de pores ; dispersion d'un matériau à base de silicium dans les structures de pores du matériau de matrice pour obtenir un matériau actif d'électrode négative (100), le matériau actif d'électrode négative (100) comprenant un matériau de matrice et un matériau à base de silicium, le matériau de matrice comprenant une pluralité de structures de pores, et au moins une partie du matériau à base de silicium étant située dans des structures de pores du matériau de matrice, au moins une partie du matériau à base de silicium ayant une structure cristalline, le matériau à base de silicium comprenant un premier matériau à base de silicium et un deuxième matériau à base de silicium ayant des tailles de grains différentes, et un rapport de taille de grains du premier matériau à base de silicium sur taille de grains du deuxième matériau à base de silicium étant (1,6 à 4): 1, une taille de grains du premier matériau à base de silicium étant supérieure à 0 nm et inférieure ou égale à 20 nm, une taille de grains du deuxième matériau à base de silicium étant supérieure à 0 nm et inférieure ou égale à 12 nm,
l'étape de dispersion du matériau à base de silicium dans les structures de pores du matériau de matrice comprenant les étapes suivantes de: placement du matériau de matrice comprenant une pluralité de structures de pores comme substrat dans un four de réaction, et alimentation d'un premier gaz de mélange comprenant un gaz source de silicium et dépôt à une première température T₁ pendant une première durée t₁, arrêt de l'alimentation du premier gaz de mélange à la fin du dépôt ; lorsque la température dans le four chute jusqu'à la deuxième température T₂, alimentation d'un deuxième gaz de mélange comprenant un gaz source de silicium, et dépôt à une deuxième température T₂ pendant une deuxième durée t₂, et après la fin du dépôt, un matériau actif d'électrode négative (100) est obtenu, une zone formée par extension depuis une surface externe de particule du matériau actif d'électrode négative (100) vers l'intérieur de la particule d'une distance de 0,5 fois une longueur entre un quelconque point de la surface externe de la particule du matériau actif d'électrode négative (100) et un noyau de particule (O) est enregistrée comme zone externe (101), et une zone à l'intérieur de la zone externe (101) est enregistrée comme une zone interne (102), et dans une image de section transversale du matériau actif d'électrode négative (100), une aire de section transversale totale du premier matériau à base de silicium dans la zone externe (101) est plus petite qu'une aire de section transversale totale du premier matériau à base de silicium dans la zone interne (102) ; et une aire de section transversale totale du deuxième matériau à base de silicium dans la zone interne (102) est plus petite qu'une aire de section transversale totale du deuxième matériau à base de silicium dans la zone externe (101),
un pourcentage en volume V₁ du gaz source de silicium dans le premier gaz de mélange est supérieur à un pourcentage en volume V₂ du gaz source de silicium dans le deuxième gaz de mélange ; et/ou,${T}_{1} > {T}_{2} ;$ et/ou,${t}_{1} < {t}_{2} ,$
la taille de grains et les aires de section transversale étant mesurées selon la description.

16. Procédé selon la revendication 15, le matériau de matrice satisfaisant au moins l'un des énoncés suivants (1) à (4):
(1) le matériau de matrice possède une porosité allant de 30 % à 60 %, éventuellement de 40 % à 50 %;
(2) le matériau de matrice comprend l'un ou plusieurs parmi un matériau de carbone, un matériau de graphite et un matériau d'oxyde de métal de transition; et
(3) le matériau de matrice comprend un matériau de carbone, et le matériau de carbone comprend l'un ou plusieurs parmi un carbone activé, un carbone de biomasse, un carbone pyrolytique et un carbone de résine;
(4) le matériau de matrice possède une taille moyenne de particule Dv50 allant de 4 µm à 12 µm.

17. Procédé selon la revendication 15 ou 16, le procédé comprenant en outre les étapes de:
avant l'alimentation du premier gaz de mélange comprenant un gaz source de silicium,
placement du matériau de matrice comprenant une pluralité de structures de pores comme substrat dans le four de réaction, et purge avec un gaz protecteur pour un traitement de purge et un traitement de préchauffage, éventuellement, la température pour un préchauffage étant de 200 °C à 300 °C;
et/ou
le premier gaz de mélange comprenant un gaz source de silicium et un gaz protecteur, et éventuellement, le pourcentage en volume V₁ du gaz source de silicium dans le premier gaz de mélange étant de 10 % à 50 %; et/ou
le premier gaz de mélange ayant un débit de gaz total allant de 0,5 L/min à 20 L/min; et/ou la première température T₁ étant de 500 °C à 700 °C; et/ou,
la première durée t₁ étant de 0,5 h à 8 h, éventuellement de 0,5 h à 4 h;
et/ou,
le deuxième gaz de mélange comprenant un gaz source de silicium et un gaz protecteur, et éventuellement, le pourcentage en volume V₂ du gaz source de silicium dans le deuxième gaz de mélange étant de 10 % à 25 %; et/ou
le deuxième gaz de mélange ayant un débit de gaz total allant de 0,5 L/min à 20 L/min; et/ou
la deuxième température T₂ étant de 500 °C à 600 °C; et/ou,
la deuxième durée t₂ étant de 4 h à 20 h, éventuellement de 4 h à 16 h; et/ou,
le débit de gaz total du deuxième gaz de mélange étant le même que celui du premier gaz de mélange.

18. Procédé selon l'une quelconque des revendications 15 à 17, comprenant en outre l'étape de : formation d'une couche de revêtement sur au moins une partie d'une surface du matériau actif d'électrode négative (100) obtenu, et la couche de revêtement comprenant l'un ou plusieurs parmi des matériaux de carbone, des polymères conducteurs, des oxydes métalliques et des sulfures métalliques; et
de préférence, l'étape de formation d'une couche de revêtement comprenant les étapes suivantes de : placement du matériau actif d'électrode négative (100) obtenu dans un four de réaction, alimentation du troisième gaz de mélange contenant un gaz source de carbone, et dépôt à une troisième température T₃ pendant une troisième durée t₃, pour obtenir un matériau actif d'électrode négative (100) revêtu de carbone; et,
plus préférablement,
le troisième gaz de mélange comprenant un gaz source de carbone et un gaz protecteur, et éventuellement, le pourcentage en volume V₃ du gaz source de carbone dans le troisième gaz de mélange étant de 10 % à 50 %; et/ou
le troisième gaz de mélange ayant un débit de gaz total allant de 0,5 L/min à 20 L/min ; et/ou
la troisième température T₃ étant de 600 °C à 800 °C; et/ou,
la troisième durée t₃ étant de 0,5 h à 4 h.

19. Batterie secondaire, comprenant une plaque d'électrode négative, la plaque d'électrode négative comprenant un matériau actif d'électrode négative (100) selon l'une quelconque des revendications 1 à 14.
